# EUROPEAN PATENT APPLICATION

(11) **EP 4 407 661 A1**
(43) Date of publication of application: **31.07.2024**
(21) Application number: 22872107.2
(22) Date of filing: 23.09.2022
(51) Int. Cl.: H01L 21/67

(54) **SUBSTRATE PROCESSING APPARATUS AND METHOD**

(30) Priority: 24.09.2021 CN 202111123098
(71) Applicant: ACM Research (Shanghai), Inc., Shanghai 201203 (CN)
(72) Inventor: WANG, Hui, Shanghai 201203 (CN); JIA, Shena, Shanghai 201203 (CN); LU, Yinxiao, Shanghai 201203 (CN); ZHANG, Xiaoyan, Shanghai 201203 (CN); WANG, Wenjun, Shanghai 201203 (CN); WANG, Jun, Shanghai 201203 (CN); SHEN, Hui, Shanghai 201203 (CN); WANG, Xi, Shanghai 201203 (CN); WANG, Jian, Shanghai 201203 (CN); CHEN, Fuping, Shanghai 201203 (CN); HAN, Yang, Shanghai 201203 (CN)
(74) Representative: Osha BWB
(86) International application number: PCT/CN2022/120824
(87) International publication number: WO 2023/046063

(57) **Abstract**

The present invention relates to the field of semiconductor equipment. Provided are a substrate processing apparatus and method. The apparatus comprises a clamp mechanism, a spray head mechanism, a rotary drive mechanism, a heating mechanism, and a control mechanism. The heating mechanism comprises a heating plate arranged below a substrate, wherein the heating plate is provided with at least two cavities in a radial direction, and the cavities are distributed at different radii. During the process of the liquid nozzle moving from the center of the substrate to the edge of the substrate along the radial direction of the substrate, when the liquid nozzle moves to a certain area above the substrate, the control mechanism controls the thermal energy of fluid in the cavity located at the corresponding radius of the area, thereby improving the local temperature of the substrate below the liquid nozzle. The apparatus can dynamically and accurately control the heating of a substrate region in a partitioned manner, thereby realizing accurate control of the surface tension and the evaporation speed of a liquid on a surface of the substrate in a drying process, and avoiding damage to fine pattern structures on the surface of the substrate in the drying process.

## Description

### BACKGROUND OF THE INVENTION

### 1. Field of the Invention

The present invention generally relates to the field of semiconductor equipment, and more particularly relates to a substrate processing apparatus and method.

### 2. The Related Art

Integrated circuit manufacturing generally refers to substrate processing and manufacturing. The substrate manufacturing process is the process of turning the design layout into a mask, transferring the circuit pattern information on the mask to a silicon wafer, and forming circuits on the silicon wafer to build a complete circuit chip. Integrated circuit manufacturing includes photolithography, etching, deposition, ion implantation, chemical mechanical polishing (CMP), cleaning and other processes. Among them, the cleaning process is to remove all kinds of contamination and impurities generated in the substrate processing and manufacturing. It is the process with the most steps in the manufacturing of integrated circuits and almost runs through the entire operation process. Contamination and impurities refer to any substances that endanger chip yield and electrical performance during the manufacturing process of integrated circuits. Specific contamination includes particles, organic substances, metals, and natural oxide layers.

Semiconductor cleaning technology is mainly divided into two process routes: wet cleaning process and dry cleaning process. In the wet cleaning process, the substrate is typically fixed on a rotatable substrate fixture, and chemical solutions and deionized water are used to process the rotating substrate surface. After wet etching or cleaning process is complete, the substrate is then subjected to drying treatment.

The traditional drying process mostly adopts nitrogen purging or isopropanol (IPA) cleaning with high-speed rotation of the substrate for drying. However, with the development of advanced integrated circuit technology, the feature size continues to shrink. During the drying process, the fine pattern structures, sizes, depths, widths, and densities on the substrate are different, and the positions from the rotation axis are different. The liquid flow and evaporation rates are also different in the pattern structures. The difference in liquid flow and evaporation rate in each fine pattern structure will lead to different liquid level heights in different pattern structures at the same time. Under the action of liquid surface tension, it will cause uneven stress on the structure between adjacent pattern structures, which will eventually lead to substrate damage problems such as collapse, adhesion, and deformation of the fine pattern structures, further causing device failure, affect chip yield, and cause product scrap.

In order to avoid the fine pattern structures on the surface of the substrate being damaged during the drying process, it is particularly important to precisely control the surface tension and evaporation rate of isopropanol (IPA) or other dry formulations on the substrate surface during the drying process. Therefore, the present invention provides a substrate processing apparatus and method.

### SUMMARY

In order to prevent the fine pattern structures of the substrate from being damaged during the drying process, and to improve the precise control of the surface tension and evaporation rate of isopropanol or other dry formula liquid on the substrate surface during the drying process, the present invention proposes a substrate processing apparatus and method.

The present invention provides a substrate processing apparatus, comprising:
a control mechanism;
a clamp mechanism, configured to hold the substrate;
a spray head mechanism, including a liquid nozzle configured to dispense liquid to a surface of the substrate positioned on the clamp mechanism;
a rotary drive mechanism, configured to drive the clamp mechanism to rotate;
a heating mechanism, includes a heating plate, wherein the heating plate is arranged under the substrate, the heating plate has at least two cavities along the radial direction, and each cavity is distributed on a different radius, the bottom of each cavity is provided with a fluid inlet hole, and the top of each cavity is provided with fluid outlet holes, and the fluid inlet hole is connected with a fluid delivery pipe;
wherein during the process of the liquid nozzle moving from the center of the substrate to the edge of the substrate along the radial direction of the substrate, when the liquid nozzle moves to a certain area above the substrate, the control mechanism controls the thermal energy of the fluid in a cavity on the radius corresponding to said certain area, thereby increasing the local temperature of the substrate under the liquid nozzle.

The present invention also provides a substrate processing method, comprising:
holding a substrate on a clamp mechanism;
driving the clamp mechanism to rotate the substrate;
dispensing liquid to a surface of the substrate via a liquid nozzle of a spray head mechanism, wherein during the process of the liquid nozzle moving from the center of the substrate to the edge of the substrate in the radial direction, when the liquid nozzle moves to a certain area above the substrate, a substrate region of which radius is the same as said certain area on the substrate is heated by jetting fluid with second thermal energy to the bottom of the substrate, and the local temperature of the substrate under the liquid nozzle is increased.

As described above, the substrate processing apparatus and method provided by the present invention can dynamically and accurately control the heating of the substrate regions in different zones, accurately control the temperature of the substrate and its surface liquid, achieving the process goal of controlling the liquid surface tension and evaporation rate at various locations on the substrate surface during the drying process and avoiding damage to the fine pattern structures of the substrate during the drying process.

Other features and advantages of the present invention will be described in subsequent specifications and, in part, will become apparent from the specifications or will be known by the implementation of the present invention. The purpose and other advantages of the present invention may be realized and obtained by means of the structure indicated in the specification and in the attached drawings.

### BRIEF DESCRIPTION OF THE DRAWINGS

In order to more clearly illustrate the embodiments of the present invention or the technical solutions in the prior art, the following will briefly introduce the drawings that need to be used in the description of the embodiments or the prior art. Obviously, the accompanying drawings in the following description are some embodiments of the present invention, those skilled in the art can also obtain other drawings based on these drawings without creative work.
Fig. 1 shows a perspective view of a substrate processing apparatus according to an embodiment of the present invention;
Fig. 2 shows a partial enlarged view of A point in Fig. 1;
Fig. 3 shows a front view of the substrate processing apparatus according to the embodiment of the present invention;
Fig. 4 shows a top view of the substrate processing apparatus according to the embodiment of the present invention;
Fig. 5 shows a sectional schematic view of section B-B in Fig. 4;
Fig. 6 shows a top view of a layout of a first chuck divided into four equal parts according to an embodiment of the present invention;
Fig. 7 shows a bottom view of the layout of the first chuck divided into four equal parts according to the embodiment of the present invention;
Fig. 8 shows a schematic view of a layout of a first fluid delivery channel in a second chuck according to an embodiment of the present invention;
Fig. 9 shows a top view of a shaft body according to an embodiment of the present invention;
Fig. 10 shows a schematic perspective view of the structure of a heating plate after the assembly of the first chuck and the second chuck according to an embodiment of the present invention;
Fig. 11 shows a cross-sectional schematic view of the assembled first chuck and second chuck according to an embodiment of the present invention;
Fig. 12 shows a top view of a layout of the first chuck divided into two equal parts according to an embodiment of the present invention;
Fig. 13 shows a top view of a layout of a first chuck according to Embodiment 3 of the present invention;
Fig. 14a and Fig. 14b show a schematic view of the relationship between fluid flow rate and heating area according to an embodiment of the present invention;
Fig. 15 shows a fluid control diagram of a substrate processing method according to Embodiment 1 of the present invention;
Fig. 16 shows a fluid control diagram of a substrate processing method according to Embodiment 4 of the present invention;
Fig. 17 shows a fluid control diagram of a substrate processing method according to Embodiment 5 of the present invention;
Fig. 18 shows a fluid control diagram of a substrate processing method according to Embodiment 6 of the present invention;
Fig. 19 shows a fluid control diagram of a substrate processing method according to Embodiment 7 of the present invention;
Fig. 20 shows a cross-sectional schematic view of the assembled first chuck and second chuck according to Embodiment 8 of the present invention;
Fig. 21 shows a cross-sectional schematic view of the assembled first chuck and second chuck according to Embodiment 9 of the present invention;
Fig. 22 shows a schematic view while a cooling part is a cooling pipe and is located inside the first chuck in Embodiment 9 of the present invention;
Fig. 23 shows a schematic view while a cooling part is a cooling pipe and is located on the upper surface of the first chuck in Embodiment 9 of the present invention;
Fig. 24 shows a schematic view of the cooling pipe in Embodiment 9 of the present invention;
Fig. 25 shows a schematic view while the cooling part is a cooling cavity in Embodiment 9 of the present invention;
Fig. 26 shows a schematic view while the cooling part is a cooling groove in Embodiment 9 of the present invention;
Fig. 27 shows an exemplary schematic view of a cooling mechanism cooling a second chuck according to an embodiment of the present invention;
Fig. 28 shows an exemplary schematic view of a cooling mechanism cooling the first chuck according to Embodiment 9 of the present invention;
Fig. 29 shows a temperature curve change graph of preheating a substrate with fluid reaching the first thermal energy according to an embodiment of the present invention;
Fig. 30a to Fig. 30c show temperature variation curves of different regions of the substrate as the liquid nozzle moves when the substrate is processed according to the substrate processing methods of Embodiment 1, Embodiment 4, and Embodiment 5 of the present invention; and
Fig. 31a to Fig. 31c show temperature variation curves of different regions of the substrate as the liquid nozzle moves when the substrate is processed according to the substrate processing method of Embodiment 7 of the present invention.

### DETAILED DESCRIPTION OF EMBODIMENTS

In order to clarify the purpose, technical solutions, and advantages of the embodiments of the present invention, the technical solutions in the embodiments of the present invention will be clearly and completely described below in conjunction with the accompanying drawings in the embodiments of the present invention. Obviously, the described embodiments are a part of embodiments of the present invention, but not all embodiments. Based on the embodiments of the present invention, all other embodiments obtained by persons of ordinary skill in the art without making creative efforts belong to the protection scope of the present invention.

### Embodiment 1

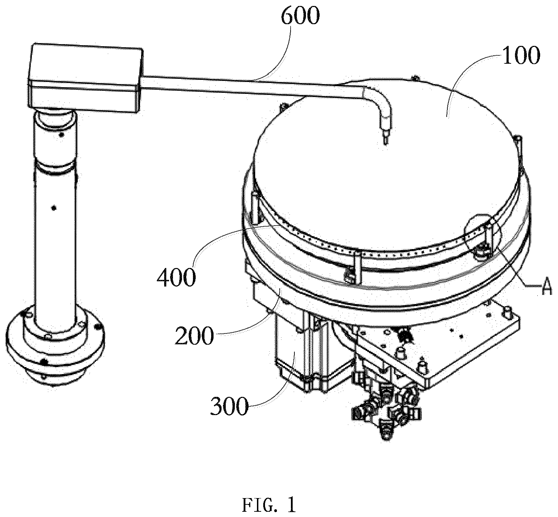

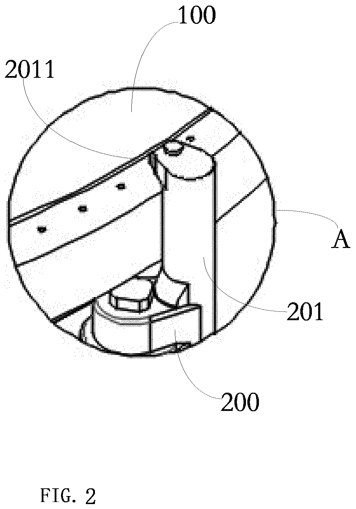

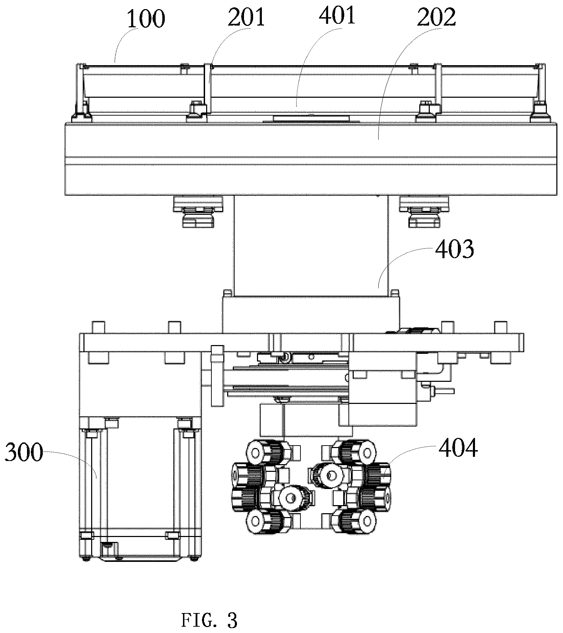

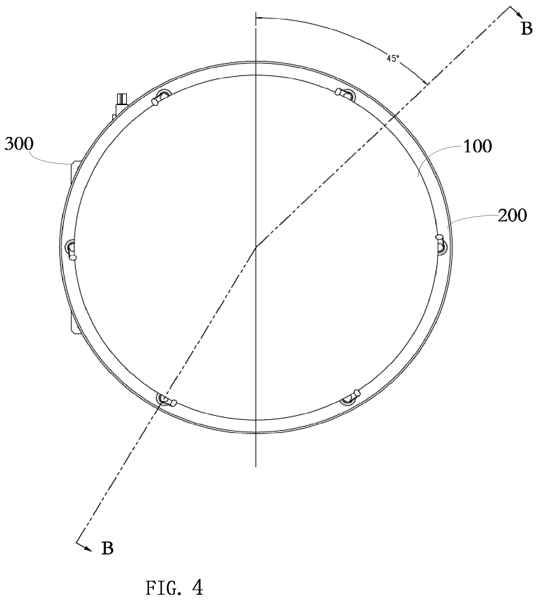

Please refer to Fig. 1 to Fig. 5 and Fig. 15 to Fig. 19. The present invention provides a substrate processing apparatus. The substrate processing apparatus includes: a clamp mechanism 200, a rotary drive mechanism 300, a heating mechanism 400, a control mechanism and a spray head mechanism 600. The clamp mechanism 200 is used to keep the substrate 100 in a horizontal state, and includes a plurality of positioning pins 201 arranged around the substrate 100. Please refer to Fig. 2. Fig. 2 is a partial enlarged view of A point in Fig. 1, showing the positions of the substrate 100 and the positioning pins 201 in the substrate processing apparatus of this embodiment, that is, the perspective view of the substrate and the positioning pins. Six positioning pins are arranged at the edge of the substrate 100. The side wall of the top of the positioning pin 201 is provided with a limit groove 2011. The bottom wall of the limit groove 2011 is used to support the substrate 100, and the side wall of the limit groove 2011 is used for clamping the substrate 100. A cylinder (not shown in figures) drives the action of a tension mechanism 203 to ensure that the positioning pin 201 can be far away from the substrate 100 to release the substrate 100, or close to the substrate 100 to clamp the substrate 100, so as to facilitate the fastening and limiting of the substrate 100, and the taking and placing of the substrate 100. The clamp mechanism 200 also includes a support part 202. The bottom end of the positioning pin 201 is detachably connected to the support part 202, and the bottom of the support part 202 is connected with a rotary drive mechanism 300 through a transmission mechanism (not shown in the figures). For example, in this embodiment, the transmission mechanism is a transmission belt, and the rotary drive mechanism 300 can be selected according to actual operation requirements during actual use. For example, in this embodiment, a servo motor is selected as the rotary drive mechanism 300. The rotary drive mechanism 300 drives the substrate 100 to rotate around a vertical line passing through the center of the substrate 100 by driving the support part 202. The middle part of the support part 202 is provided with a through hole penetrating up and down to accommodate some non-rotating components.

The heating mechanism 400 includes a heating plate and a fluid delivery unit. The heating plate is arranged under the substrate 100, accommodated in the through hole opened in the middle of the support part 202, and arranged parallel to the substrate 100 during operation. The heating plate includes a first chuck 401 and a second chuck 402 that are set in a matching manner. Blocks are disposed on the first chuck 401, and slots are disposed on the second chuck 402. During installation, the blocks of the first chuck 401 are engaged in the slots of the second chuck 402 to form a stable structure. The first chuck 401 is equally divided into n equal parts according to the angle, wherein, n is an integer greater than or equal to 2. The first chuck 401 has at least two cavities 4011 along the radial direction. Each cavity 4011 is distributed on different radius along the radial direction of the first chuck 401. The number of cavities 4011 in each equal part is equal, and the cavities 4011 are distributed on different radii. A fluid inlet hole 4012 is opened at the bottom of the cavity 4011, and a fluid outlet hole 4013 is opened at the top of the cavity 4011. The density of the fluid outlet holes 4013 opened on the cavities 4011 is same. The second chuck 402 is arranged below the first chuck 401 for fixing and supporting the first chuck 401 and connecting the first chuck 401 and the fluid delivery unit. The second chuck 402 is provided with first fluid delivery channels 4021 and the number of the first fluid delivery channels 4021 is equal to the number of the cavities 4011. One end of the first fluid delivery channel 4021 in the second chuck 402 communicates with the fluid inlet hole 4012 at the bottom of the cavity 4011 opened in the first chuck 401. The other end of the first fluid delivery channel 4021 communicates with the fluid delivery unit. During the process, the substrate 100 is rotating and the heating mechanism 400 is not rotating. After rotating the substrate 100 for one cycle, the region of the substrate 100 heated by each cavity 4011 is a ring or a circle.

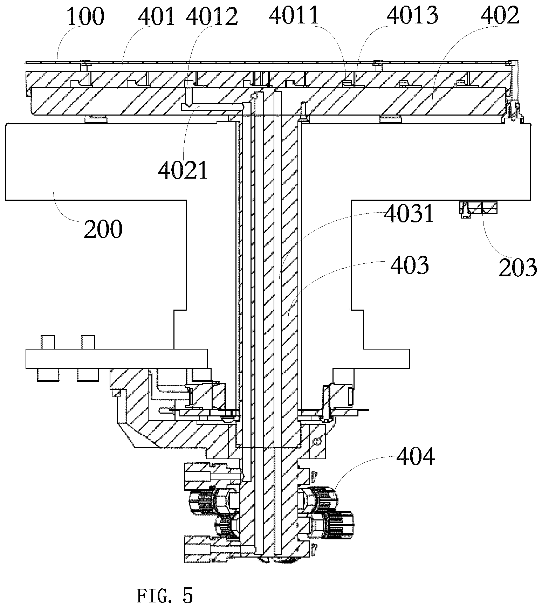

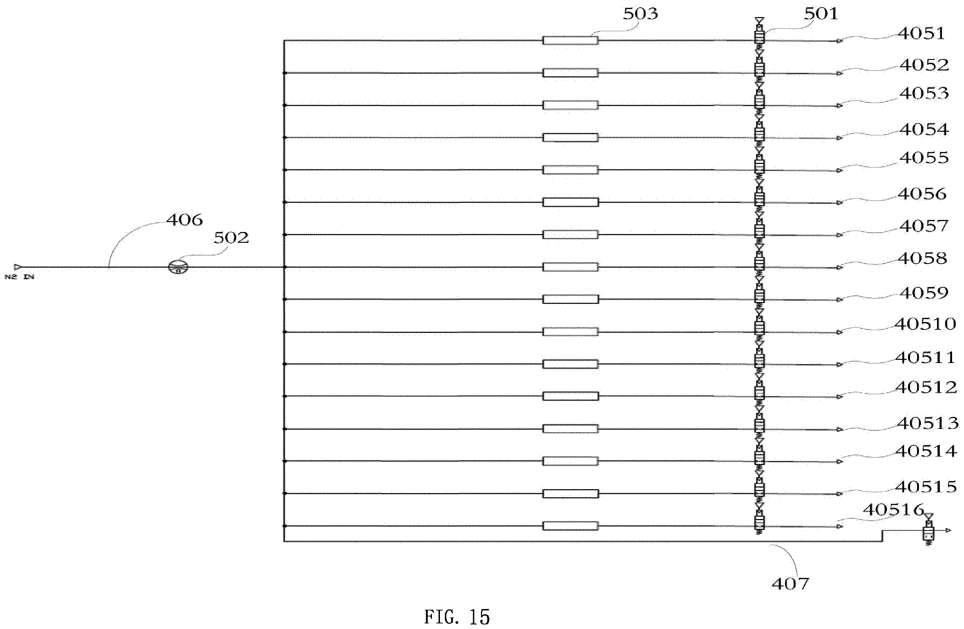

Referring to Fig. 5 and Fig. 15, the fluid delivery unit includes a shaft body 403, connectors 404, fluid delivery pipes and a fluid delivery main pipe 406. One end of the shaft body 403 is fixedly connected to the bottom of the second chuck 402. Second fluid delivery channels 4031 are arranged in the shaft body 403, and the number of the second fluid delivery channels 4031 is equal to the number of the cavities 4011. One end of the second fluid delivery channel 4031 is connected to the first fluid delivery channel 4021 in the second chuck 402. The lateral wall of the shaft body 403 is provided with openings and the number of the openings is equal to the number of the second fluid delivery channels 4031. Each opening is equipped with a connector 404, and each connector 404 is connected to a fluid delivery pipe. Multiple fluid delivery pipes are simultaneously connected to the same fluid delivery main pipe 406.

The control mechanism includes on-off valves 501, a mass flow controller 502 and heaters 503. The fluid delivery pipes connected to each cavity 4011 are respectively communicated with the same fluid delivery main pipe 406. An on-off valve 501 and a heater 503 are arranged on each fluid delivery pipe, and a mass flow controller 502 is arranged on the fluid delivery main pipe 406. The on-off valve 501 opens or closes the fluid flowing through the fluid delivery pipe; the mass flow controller 502 is configured to monitor and adjust the flow rate of the fluid flowing through the fluid delivery main pipe 406; the heater 503 is configured to heat the fluid in the fluid delivery pipe. The control mechanism controls the thermal energy of the fluid in the cavity 4011 below the substrate 100 corresponding to the liquid nozzle, thereby increasing the local temperature of the substrate 100 under the liquid nozzle.

The spray head mechanism 600 includes a liquid nozzle configured to dispense liquid onto the surface of the substrate 100 placed on the clamp mechanism 200.

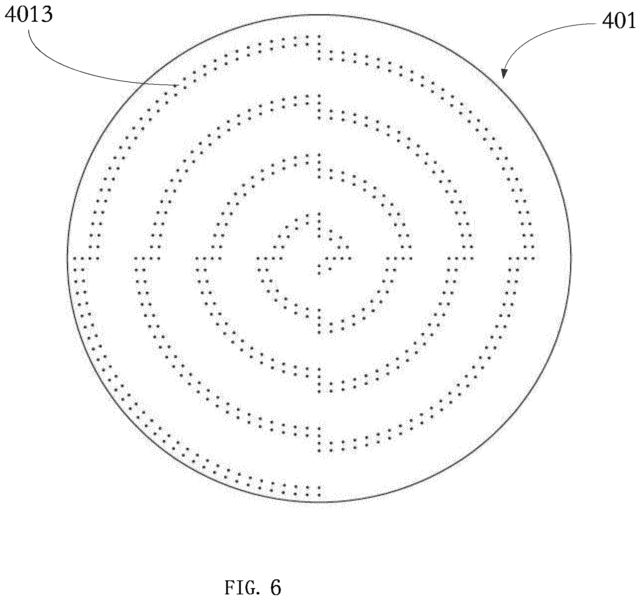

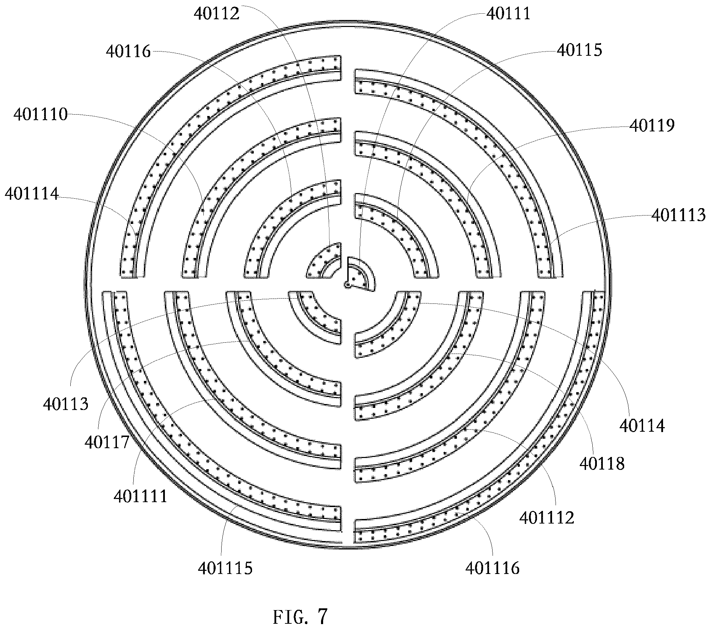

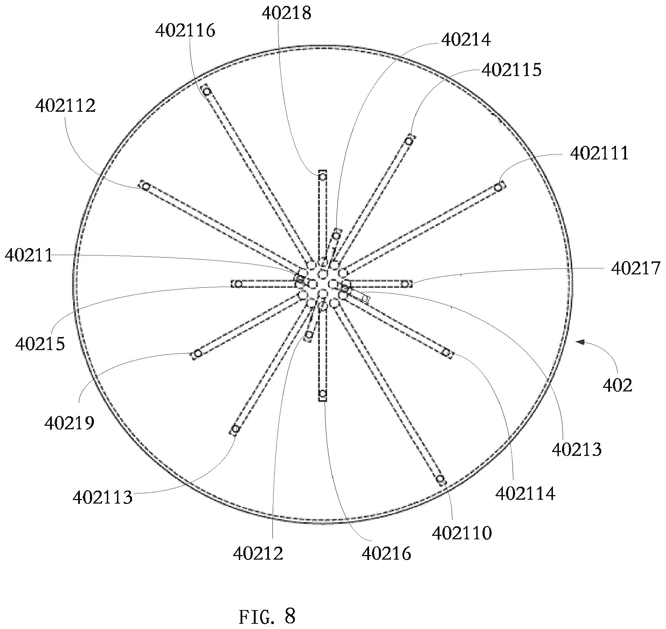

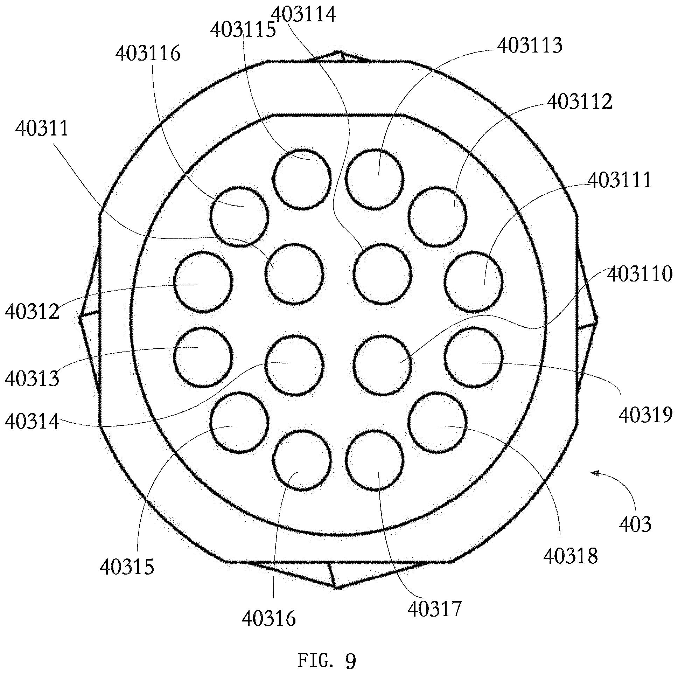

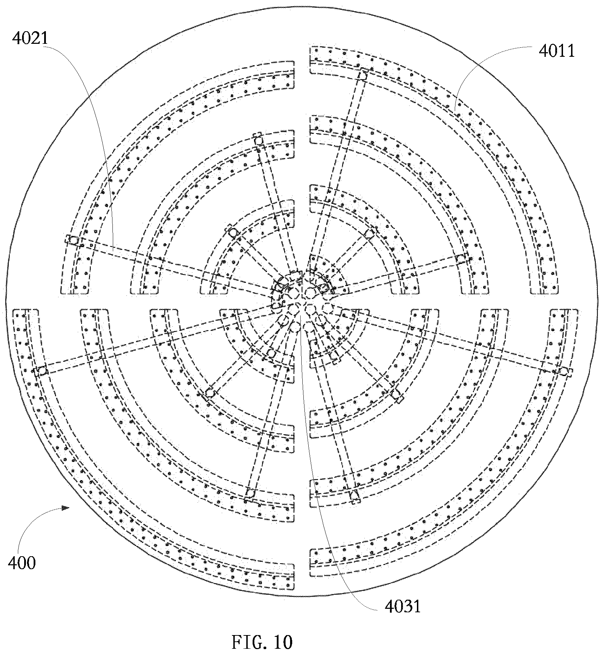

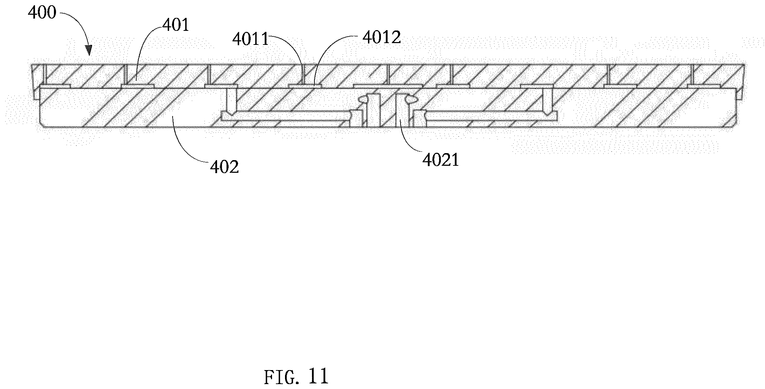

Please refer to Fig. 6 to Fig. 11. In the embodiment of the present invention, the layout design of the first chuck 401 is: the first chuck 401 is divided into 4 equal parts according to the angle, that is, the first chuck 401 is divided into four quadrants, and the first chuck 401 has 16 cavities 4011 in the radial direction, and these 16 cavities 4011 are evenly distributed in the four quadrants of the first chuck 401. Fig. 6 shows a top view of the layout of the first chuck 401 divided into four equal parts. Fig. 7 shows a bottom view of the layout of the first chuck 401 divided into four equal parts. Fig. 8 shows a schematic view of the layout of the first fluid delivery channels 4021 in the second chuck 402. Fig. 9 shows a top view of the shaft body 403. Fig. 10 shows a schematic perspective view of the structure of the heating plate after the first chuck 401 and the second chuck 402 are assembled. Fig. 11 shows a cross-sectional schematic view of the assembled first chuck 401 and second chuck 402.

The apparatus of the present invention is not only suitable for drying the substrate 100 after a wet etching or cleaning process is completed, but also can be used in an etching process.

The embodiment of the present invention also provides a substrate processing method. Please refer to Fig. 15, which shows a fluid control diagram according to the embodiment of the present invention. During operation, the clamp mechanism 200 clamps the substrate 100 to maintain the horizontal setting of the substrate 100. The spray head mechanism 600 is located above the substrate 100. The rotary drive mechanism 300 drives the substrate 100 to rotate around the vertical line passing through the center of the substrate 100 by driving the support part 202. In this embodiment, the liquid dispensed by the liquid nozzle of the spray head mechanism 600 to the substrate 100 is dry liquid IPA. When the liquid nozzle moves above the center of the substrate 100, before dispensing the liquid to the surface of the substrate 100, the control mechanism controls the heaters 503 to heat the thermal energy of the fluid flowing through the fluid delivery pipes to the first thermal energy. The fluid reaching the first thermal energy heats the substrate 100 to the first temperature through the fluid outlet holes 4013 of each cavity 4011. The first temperature is a preheating temperature, and its function is to uniformly heat the entire substrate 100. Taking IPA as an example, the preferred process temperature range is 60-70° C. The first thermal energy refers to the thermal energy required to heat the substrate 100 to the first temperature.

During the movement of the liquid nozzle from the center of the substrate 100 to the edge of the substrate 100 along the radial direction of the substrate 100, when the liquid nozzle moves to a certain area above the substrate 100, the control mechanism controls the heater 503 to heat the fluid in the cavity 4011 located at the radius corresponding to the certain area to the second thermal energy. And the fluid reaching the second thermal energy passes through the fluid outlet holes 4013 of the cavity 4011 to heat the substrate 100 in this certain area to the second temperature. The second temperature is approximate the temperature at which the liquid dispensed by the liquid nozzle to substrate 100 reaches the boiling point. In this embodiment, the second temperature is greater than or equal to the boiling point of the liquid. Taking IPA as an example, the preferred process temperature range is 78-85 ° C.

As an example, before the liquid nozzle dispensing the liquid, the fluid transported into the cavities 4011 is first heated, and the fluid is transported to the first fluid delivery channels 4021 in the second chuck 402 of the heating plate through the fluid delivery pipes and the second fluid delivery channels 4031. The fluid then enters the cavities 4011 of the first chuck 401, and then flows out of the heating plate through the fluid outlet holes 4013 opened on the top of the cavities 4011 to heat the substrate 100 above the heating plate to 70° C.

When the liquid nozzle dispenses liquid to the surface of the substrate 100, as the liquid nozzle moves, when the liquid nozzle moves to a certain area above the substrate 100, the control mechanism controls the heater 503 to heat the fluid in the fluid delivery pipe connected to the cavity 4011 located at the radius corresponding to the certain area. And then control the thermal energy of the fluid flowing out of the fluid outlet holes 4013 of the cavity 4011 on the radius to be the second thermal energy. The fluid reaching the second thermal energy heats the substrate 100 to 80° C through the fluid outlet holes 4013 of the cavity 4011.

More specifically, referring to Fig. 7, the 16 cavities 4011 opened on the first chuck 401 are numbered from the center to the edge of the first chuck 401 in the order of cavities whose radii gradually increase, and the specific numbers are respectively 40111, 40112, 40113, 40114, 40115, 40116, 40117, 40118, 40119, 401110, 401111, 401112, 401113, 401114, 401115, 401116. Please refer to Fig. 8 for the structural schematic view of the corresponding second chuck 402. The numbers of the first fluid delivery channels 4021 which are connected to the cavities 4011 and are arranged in the second chuck 402, are 40211, 40212, 40213, 40214, 40215, 40215, 40216, 40217, 40218, 40219, 402110, 402111, 402112, 402113, 402114, 402115 and 402116 respectively. Referring to Fig. 9, there are corresponding numbers of second fluid delivery channels 4031 in the shaft body 403, numbered respectively 40311, 40312, 40313, 40314, 40315, 40316, 40317, 40318, 40319, 403110, 403111, 403112, 403113, 403114, 403115, 403116. Please refer to Fig. 10 and Fig. 11, which both show perspective views of the structure of the heating plate after the first chuck 401 and the second chuck 402 are assembled. Referring to Fig. 5 and Fig. 15, the shaft body 403 connects 16 fluid delivery pipes numbered 4051, 4052, 4053, 4054, 4055, 4056, 4057, 4058, 4059, 40510, 40511, 40512, 40513, 40514, 40515, 40516 through connectors 404. An on-off valve 501 and a heater 503 are respectively arranged on each fluid delivery pipe. The multiple fluid delivery pipes are connected to the same fluid delivery main pipe 406, and a mass flow controller 502 is arranged on the fluid delivery main pipe 406.

Before the liquid nozzle starts dispensing liquid to the substrate 100, the control mechanism controls the heater 503 on each fluid delivery pipe to heat the fluid flowing through the fluid delivery pipe so that its thermal energy reaches the first thermal energy. Before the thermal energy of the fluid reaches the first thermal energy, the fluid passes through the bypass branch pipe 407 and is discharged out of the apparatus, and the fluid that reaches the first thermal energy heats the substrate 100 to 70° C through the fluid outlet holes 4013 of each cavity 4011.

When the liquid nozzle starts to dispense liquid to the substrate 100 and simultaneously moves from the center of the substrate 100 to the edge of the substrate 100 along the radial direction of the substrate 100, when the liquid nozzle moves to a certain area above the substrate 100, the cavity number 40111 is located on the radius of the heating plate corresponding to the certain area. The control mechanism controls the heater 503 on the fluid delivery pipe numbered 4051 communicated with the cavity 40111 to start heating, so that the heater 503 heats the fluid flowing through the fluid delivery pipe numbered 4051 to the second thermal energy. Specifically, the control mechanism controls the heater 503 set on the fluid delivery pipe 4051 to start working to heat the fluid in the pipe. And before the thermal energy of the fluid in the pipe reaches the second thermal energy, the fluid is first discharged to the outside of the apparatus via the bypass branch pipe 407. When the thermal energy of the fluid reaches the target thermal energy, it is transported into the cavity 40111 through the fluid delivery pipe 4051 to ensure that the thermal energy of the fluid supplied by the pipe to the heating plate reaches the set second thermal energy. The fluid flows out of the heating plate through the fluid outlet holes 4013 opened on the cavity 40111, and flows to the substrate 100, heating the substrate 100 region corresponding to the radius area that the cavity 40111 is located on to make the temperature at the substrate 100 region be rapidly heated to 80°C. The liquid at the substrate 100 region vaporizes rapidly, and when the vaporization process of the liquid is fast enough, at the moment of drying, instead of being dried by the liquid, it is vaporized and dried, thereby reducing the surface tension. The tension of the liquid surface is negligible for the pulling force between adjacent pattern structures. During this process, there is no pull of liquid surface tension between adjacent pattern structures, which effectively prevents the fine pattern structures on the surface of the substrate 100 from being damaged during drying.

The heated fluid can be a gas, such as clean air, nitrogen, or an inert gas. The heated fluid can also be a liquid.

When the apparatus is used for IPA drying, the spray head mechanism 600 further includes a nitrogen nozzle for nitrogen purging.

When the apparatus is used in the wet etching process, the etching chemical liquid or formula liquid is delivered to the surface of the rotating substrate through the spray head mechanism, and the film on the surface of the substrate is partially etched or completely removed.

In the wet etching process, generally, the etching chemical liquid or formula liquid is delivered to the surface of the rotating substrate 100 through the spray head mechanism 600, and the film on the surface of the substrate 100 is partially etched or completely removed. Because temperature is one of the important parameters affecting the corrosion rate and uniformity. Through the apparatus of the present application and the above-mentioned processing method, the temperature of the substrate and its surface liquid can be dynamically and accurately controlled in partitions, so as to obtain good etching rate and uniformity control and improve the processing accuracy and stability of integrated circuit wet etching process.

Among them, when the etching chemical solution includes but not limited to hydrofluoric acid, ammonia water, hydrochloric acid, sulfuric acid, hydrogen peroxide, hydrofluoric acid nitric acid mixed solution, hydrofluoric acid ammonium fluoride mixed solution, ammonia hydrogen peroxide and pure water mixed solution, hydrochloric acid hydrogen peroxide and pure water mixed solution, etc. The second temperature range is 19-75° C.

When the etching chemical solution includes but not limited to sulfuric acid hydrogen peroxide mixed solution, the second temperature range is 80-200° C.

When the etching chemical solution includes but not limited to phosphoric acid, the second temperature range is 120-165° C.

### Embodiment 2

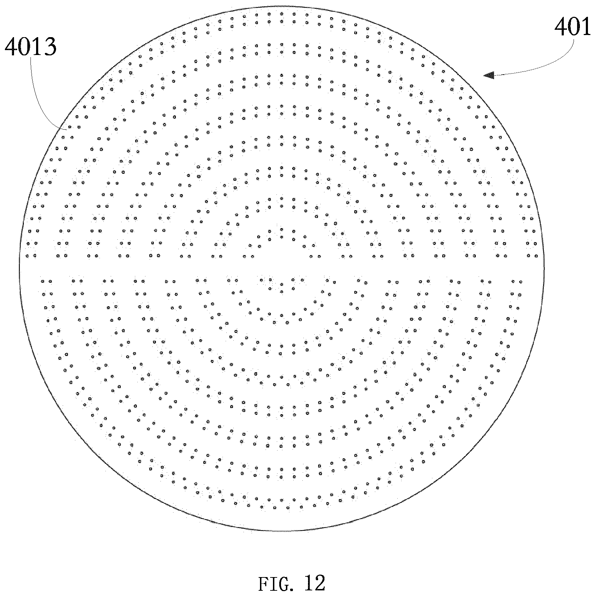

This embodiment provides a substrate processing apparatus. The structure of the apparatus is substantially the same as that of the substrate processing apparatus in Embodiment 1. The difference is that, as shown in Fig. 12, the first chuck 401 is equally divided into 2 equal parts. The first chuck 401 has 16 cavities in the radial direction, and the upper end surface of each cavity has evenly distributed fluid outlet holes 4013. And the 16 cavities are evenly distributed in two regions of the first chuck 401. There are 8 cavities in each of the two regions. Fig. 12 is a top view of the layout of the first chuck 401.

All the other structures are the same as in Embodiment 1.

### Embodiment 3

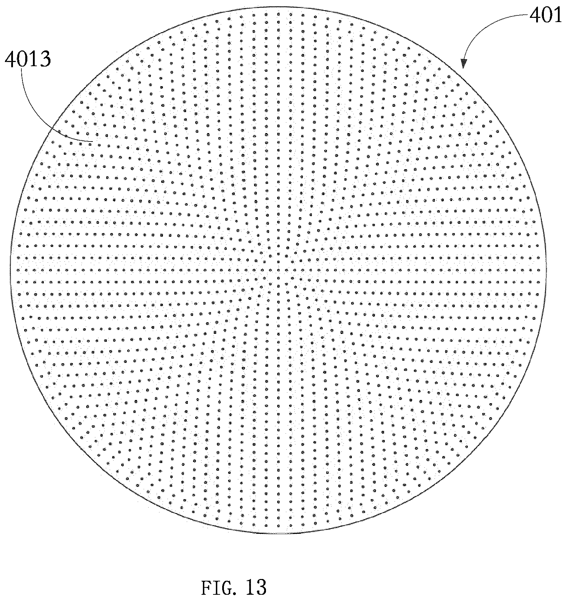

This embodiment provides a substrate processing apparatus, the structure of which is substantially the same as that of the substrate processing apparatus in Embodiment 1, and the difference is that, as shown in Fig. 13, the first chuck 401 is used as a whole, and 16 cavities are directly opened along the radial direction on the first chuck 401. The upper end surface of each cavity is provided with evenly distributed fluid outlet holes 4013. The 16 cavities 4011 are uniformly arranged at different radii within the first chuck 401. The shape of the 16 cavities 4011 is circular and arranged concentrically. Fig. 13 is a top view of the layout of the first chuck 401 in this way.

All the other structures are the same as in Embodiment 1.

### Embodiment 4

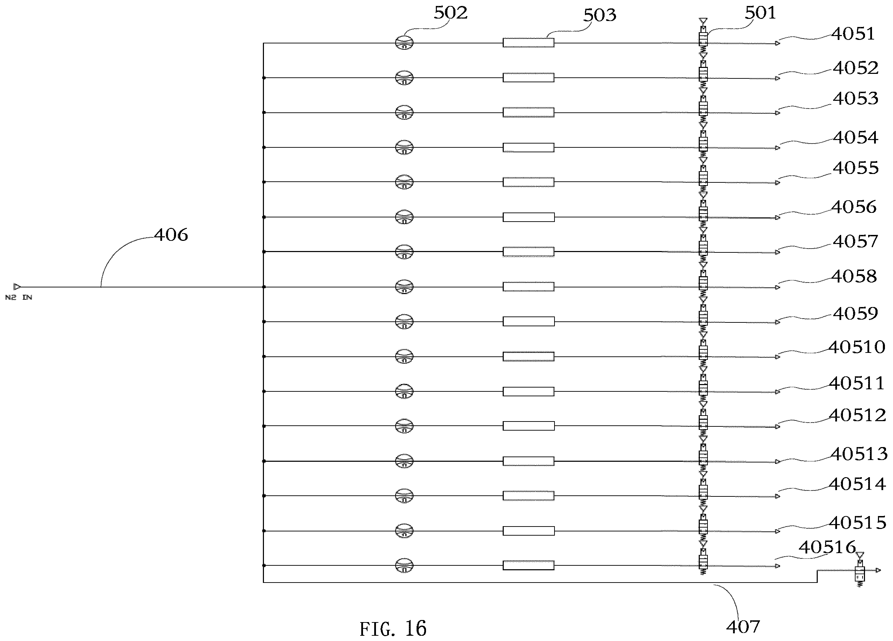

This embodiment provides a substrate processing apparatus, the structure of which is substantially the same as the structure of the substrate processing apparatus in Embodiment 1. The difference is that, as shown in Fig. 16, an on-off valve 501, a mass flow controller 502, and a heater 503 are respectively arranged on the fluid delivery pipe connected to each cavity. The on-off valve 501 is configured to control the switch of the fluid flowing through the fluid delivery pipe. The mass flow controller 502 is configured to monitor and adjust the flow rate of the fluid passing through each fluid delivery pipe. The heater 503 is configured to heat the fluid inside the fluid delivery pipe. By adjusting the mass flow controller 502 from the fluid delivery main pipe 406 in the first embodiment to set it on the fluid delivery pipe, the flow rate of the fluid can be controlled by controlling and adjusting the mass flow controller 502 to regulate the flow rate of the fluid, thereby controlling the heating of the fluid to the substrate 100, and also by controlling the heater 503 to heat the fluid inside the fluid delivery pipe to adjust the fluid temperature, and further controlling the fluid to heat the substrate 100. In the actual process, the mass flow controller 502 can be controlled and adjusted separately, or the heater 503 can be controlled and adjusted separately, or both the mass flow controller 502 and the heater 503 can be adjusted at the same time. Multiple control schemes can adapt to various situations, making it more convenient, efficient, adjustable, controllable, and precise.

The other structures of this embodiment are the same as that of Embodiment 1.

The substrate processing method corresponding to this embodiment is substantially the same as that in Embodiment 1. The difference is that in this embodiment, the thermal energy of the fluid inside each fluid delivery pipe is controlled by controlling the mass flow controller to adjust the flow rate of the fluid in the cavity located at the radius corresponding to the certain area and/or by controlling the heater to adjust the thermal energy of the fluid in the cavity located at the radius corresponding to the certain area, thereby controlling the thermal energy of the fluid in the cavity 4011 below the substrate 100 corresponding to the liquid nozzle to make the thermal energy of the fluid sprayed out from the fluid outlet holes 4013 on the cavity 4011 reach the second thermal energy, and the fluid with the second thermal energy heats the substrate 100 to the second temperature. During the movement of the liquid nozzle along the radial direction of the substrate 100 from the center of the substrate 100 to the edge of the substrate 100, the control mechanism controls the flow rate of the fluid in the cavities 4011 arranged radially from the center of the substrate 100 to the edge of the substrate 100 to gradually increase to ensure faster heating of the corresponding region of the substrate 100, so that the local temperature of the substrate 100 rapidly rises to the second temperature.

When adjusting the flow rate of the fluid by controlling and adjusting the mass flow controller 502 to realize the thermal energy contained in the fluid reaches the second thermal energy, the control mechanism adjusts the flow rate of the fluid through the mass flow controller 502 according to the actual region and uniformity of heating of the substrate 100, thereby achieving the above purpose and effect.

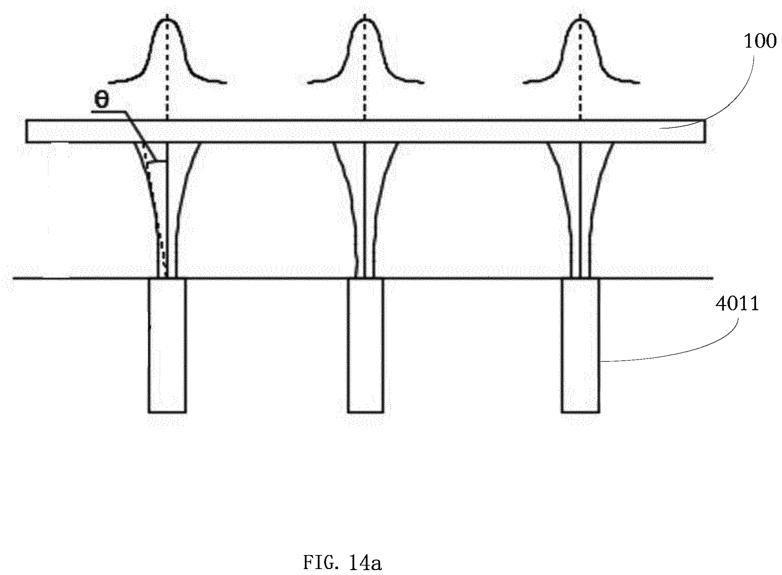

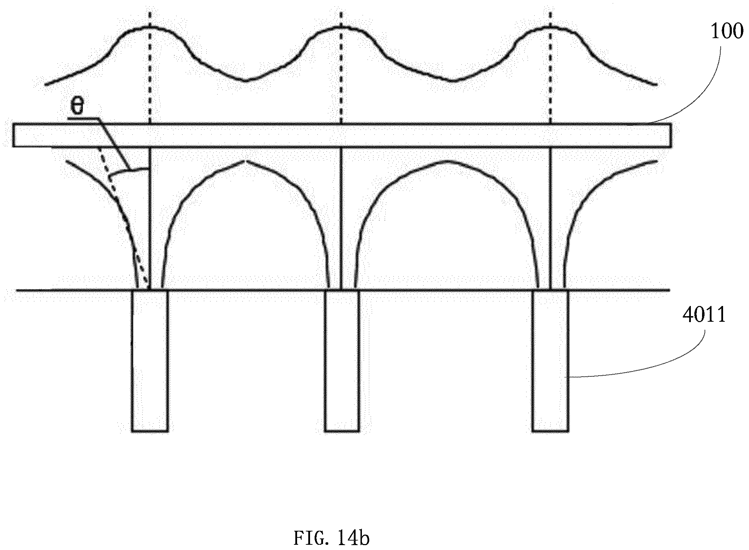

Please refer to Figs. 14a and 14b for details, which show the flow velocity of the jet flow and the trajectory of the fluid jet flow exiting from fluid outlet holes 4013. By adjusting the mass flow controller 502 on each fluid delivery pipe, the flow velocity of the fluid flowing out from the fluid outlet holes 4013 can be changed, thereby altering the size of the θ angle. The 2 θ angle represents the apex angle of the cone formed by the boundary of the trajectory of fluid jet flow. A higher flow velocity, a smaller θ angle, leading to a smaller heating region of the substrate 100 corresponding to the cavity 4011 under that flow velocity condition. Conversely, a lower flow velocity, a larger θ angle, leading to a larger heating region of the substrate 100 corresponding to the cavity 4011 under that flow velocity condition. When the θ angle is larger, it indicates that the fluid jetting out from fluid outlet hole 4013 has a larger heating region on substrate 100, capable of preheating the substrate 100 region corresponding to the adjacent cavity which is next to the cavity 4011 while heating the substrate 100 region corresponding to the cavity 4011. Therefore, when heating the substrate 100 region corresponding to the adjacent cavity which is next to the cavity 4011, the time required for the substrate 100 to reach the desired temperature will be reduced, resulting in higher efficiency.

In this embodiment, when the adjustment of the thermal energy contained in the fluid is realized by the heater 503, the control method is the same as that in Embodiment 1.

### Embodiment 5

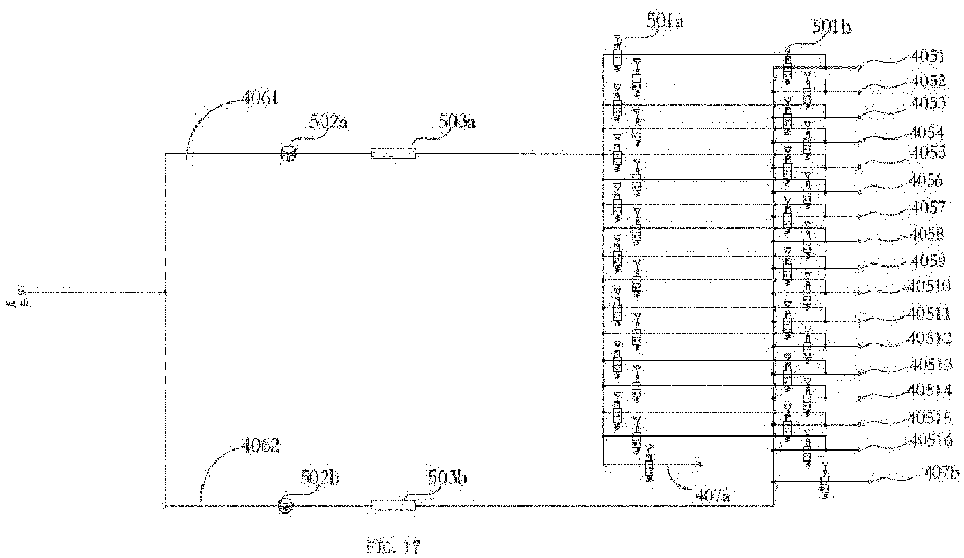

This embodiment provides a substrate processing apparatus, the structure of which is substantially the same as that of the substrate processing apparatus in Embodiment 1. The difference is that, as shown in Fig. 17, the fluid delivery pipe connecting to each cavity is connected to a first fluid delivery branch pipe and a second fluid delivery branch pipe. An on-off valve 501a is installed on the first fluid delivery branch pipe, and an on-off valve 501b is installed on the second fluid delivery branch pipe.

The first fluid delivery branch pipes are connected to a first fluid delivery main pipe 4061, and the second fluid delivery branch pipes are connected to a second fluid delivery main pipe 4062. A mass flow controller 502a and a heater 503a are set on the first fluid delivery main pipe 4061, and a mass flow controller 502b and a heater 503b are set on the second fluid delivery main pipe 4062. Among them, the on-off valves 501a, 501b are configured to open or close the fluid flowing through the respective fluid delivery branch pipes. The mass flow controllers 502a, 502b are configured to monitor and adjust the flow rate of the fluid flowing through the first fluid delivery main pipe 4061, the second fluid delivery main pipe 4062. The heaters 503a and 503b are configured to heat the fluid in the first fluid delivery main pipe 4061 and the second fluid delivery main pipe 4062. The first fluid delivery main pipe 4061 is connected with a bypass branch pipe 407a, and the second fluid delivery main pipe 4062 is connected with a bypass branch pipe 407b.

The other structures of this embodiment are the same as that of Embodiment 1.

The substrate processing method corresponding to this embodiment is substantially the same as that of Embodiment 1. The difference is that: in this embodiment, the fluid delivery main pipe is set as two main pipes 4061, 4062. And each fluid delivery pipe is connected with two fluid delivery branch pipes, and the two fluid delivery branch pipes are connected to the two fluid delivery main pipes 4061 and 4062.

During the process of the control mechanism controlling the heating mechanism 400 to heat the substrate 100, first, all the on-off valves 501a on the first fluid delivery branch pipes connected to the first fluid delivery main pipe 4061 are controlled to open. The heater 503a is controlled to heat the fluid flowing through the first fluid delivery main pipe 4061, and the fluid passes through the first fluid delivery branch pipes and fluid delivery pipes to flow through the fluid outlet holes 4013 of each cavity to preheat the whole substrate 100 to a first temperature. Before the thermal energy of the fluid in the first fluid delivery main pipe 4061 reaches the first thermal energy, the fluid is discharged outside the apparatus through the bypass branch pipe 407a.

During the movement of the liquid nozzle along the radial direction of the substrate 100 from the center of the substrate to the edge of the substrate, when the liquid nozzle moves to a certain area above the substrate 100, the on-off valve 501a on the first fluid delivery branch pipe connected to the fluid delivery pipe connected to the cavity on the radius of the heating plate corresponding to said certain area is closed, while the on-off valve 501b on the second fluid delivery branch pipe is opened. The fluid flowing through the second fluid delivery main pipe 4062 connected to the cavity below the substrate 100 corresponding to the position of the liquid nozzle is heated, and the fluid passes through the fluid outlet holes 4013 of the cavity to heat the substrate region corresponding to the position of the liquid nozzle to a second temperature. Before the thermal energy of the fluid in the second fluid delivery main pipe 4062 reaches the second thermal energy, the fluid is discharged to the outside of the apparatus through the bypass branch pipe 407b.

By setting two fluid delivery main pipes 4061 and 4062, and the thermal energy of the fluid in the two fluid delivery main pipes 4061 and 4062 is different. The first fluid delivery main pipe 4061 can preheat the whole substrate 100. The fluid in the second fluid delivery main pipe 4062 is heated to the second thermal energy before the second fluid delivery main pipe 4062 delivers the fluid to fluid delivery pipes. While the fluid flows to the fluid delivery pipes, temperature switching is faster, the control of heating the substrate 100 is more precise, and the work efficiency is higher.

### Embodiment 6

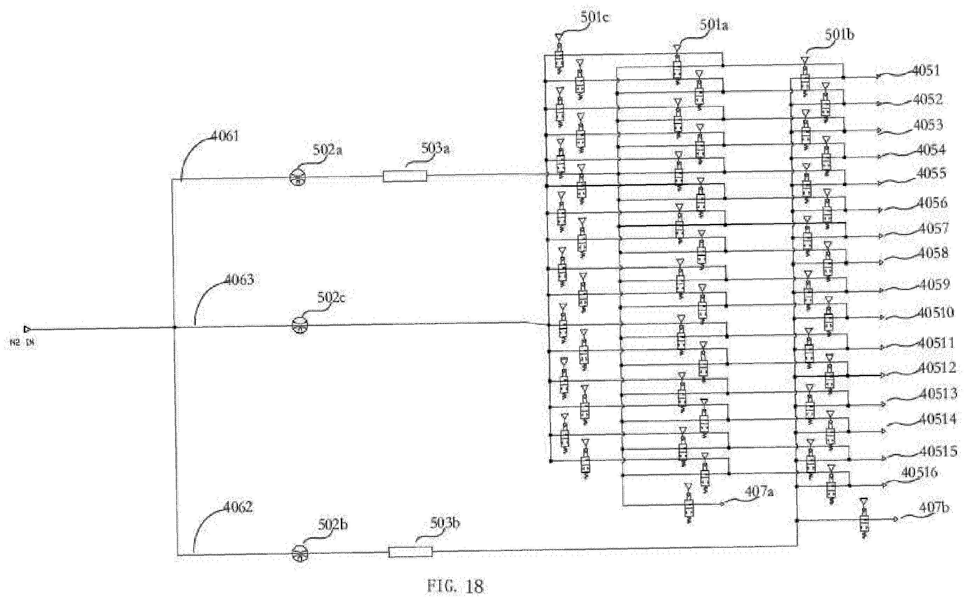

This embodiment provides a substrate processing apparatus, the structure of which is substantially the same as the substrate processing apparatus in Embodiment 5. The difference is that, as shown in Fig. 18, a fluid delivery pipe connected to each cavity is connected to a first fluid delivery branch pipe, a second fluid delivery branch pipe, and a third fluid delivery branch pipe. An on-off valve 501a is installed on the first fluid delivery branch pipe. An on-off valve 501b is installed on the second fluid delivery branch pipe. An on-off valve 501c is installed on the third fluid delivery branch pipe. The first fluid delivery branch pipes are connected to a first fluid delivery main pipe 4061, the second fluid delivery branch pipes are connected to a second fluid delivery main pipe 4062, and the third fluid delivery branch pipes are connected to a third fluid delivery main pipe 4063. The first fluid delivery main pipe 4061 is connected to a bypass branch pipe 407a, and the second fluid delivery main pipe 4062 is connected to a bypass branch pipe 407b. Mass flow controllers 502a, 502b, 502c are installed on the first, second, and third fluid delivery main pipes 4061, 4062, 4063 respectively. Heaters 503a, 503b are installed on the first and second fluid delivery main pipes 4061, 4062 respectively. The on-off valves 501a, 501b, 501c are configured to open or close the fluid flowing through their respective fluid delivery branch pipes. The mass flow controllers 502a, 502b, 502c are configured to monitor and adjust the flow rate of the fluid flowing through the fluid delivery main pipes 4061, 4062, 4063. The heaters 503a, 503b are configured to heat the fluid inside the first and second fluid delivery main pipes 4061, 4062.

The other the structures of this embodiment are the same as that of Embodiment 1.

After the substrate 100 is taken from the clamp mechanism 200, the heating plate needs to be cooled so as to proceed with the next substrate process. At this time, close the on-off valves 501a and 501b set on the first and second fluid delivery branch pipes connected to the first and second fluid delivery main pipes 4061, 4062, and open the on-off valve 501c set on the third fluid delivery branch pipe connected to the fluid delivery main pipe 4063, which allows low-temperature fluid to be delivered to each cavity of the heating plate, rapidly cooling the heating plate, accelerating the cooling speed of the heating plate, and improving process efficiency.

The low-temperature fluid here refers to fluid with a temperature lower than room temperature. The low-temperature fluid flows out from the fluid outlet holes 4013 of the heating plate, spreads around, and flows through the clamp mechanism 200, cooling the clamp mechanism 200 during the cooling treatment of the heating plate.

During the cooling process, in order to prevent frequent switching of the heaters 503a and 503b from affecting their lifespan, the fluid inside the first fluid delivery main pipe 4061 and the second fluid delivery main pipe 4062 is discharged to the outside of the apparatus through the bypass branch pipes 407a and 407b. When the next substrate 100 enters the apparatus for drying, it can quickly switch to the fluid with the required thermal energy to accurately control the temperature of regions of the substrate 100.

### Embodiment 7

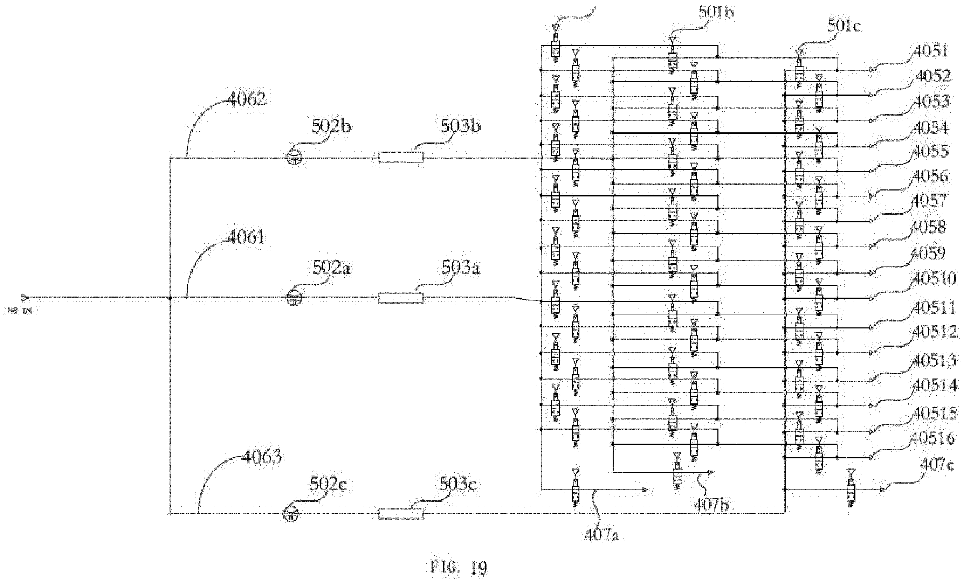

This embodiment provides a substrate processing apparatus, the structure of which is substantially the same as the substrate processing apparatus in Embodiment 1. The difference is that, as shown in Fig. 19, a fluid delivery pipe connected to each cavity is connected to a first fluid delivery branch pipe, a second fluid delivery branch pipe, and a third fluid delivery branch pipe. An on-off valve 501a is installed on the first fluid delivery branch pipe. An on-off valve 501b is installed on the second fluid delivery branch pipe. An on-off valve 501c is installed on the third fluid delivery branch pipe. The first fluid delivery branch pipe is connected to the first fluid delivery main pipe 4061. The second fluid delivery branch pipe is connected to the second fluid delivery main pipe 4062. The third fluid delivery branch pipe is connected to the third fluid delivery main pipe 4063. A mass flow controller 502a, 502b, 502c and a heater 503a, 503b, 503c are installed on each of the first, second, and third fluid delivery main pipes 4061, 4062, 4063. The on-off valves 501a, 501b, 501c are configured to open or close the flow of fluid through their respective fluid delivery branch pipes. The mass flow controllers 502a, 502b, 502c are configured to monitor and adjust the flow rate of fluid through each fluid delivery main pipe 4061, 4062, 4063. The heaters 503a, 503b, 503c are configured to heat the fluid inside the respective fluid delivery main pipes 4061, 4062, 4063. The first fluid delivery main pipe 4061 is connected to a bypass branch pipe 407a, the second fluid delivery main pipe 4062 is connected to a bypass branch pipe 407b, and the third fluid delivery main pipe 4063 is connected to a bypass branch pipe 407c.

The other structures of this embodiment are the same as that of Embodiment 1.

The substrate processing method corresponding to this embodiment is substantially the same as that of Embodiment 1. The difference is that in this embodiment, the fluid delivery main pipe includes three fluid delivery main pipes, and each fluid delivery pipe is connected to three fluid delivery branch pipes, and the three fluid delivery branch pipes are respectively connected to the three fluid delivery main pipes.

During the process of the control mechanism 500 controlling the heating mechanism 400 to heat the substrate 100, the control mechanism controls the heater 503a to heat the fluid flowing through the first fluid delivery main pipe 4061. The heated fluid is then used to heat the substrate 100 to the first temperature through the fluid outlet holes 4013 of each cavity.

During the process of the liquid nozzle moving radially along the substrate 100 from the center of the substrate 100 towards the edge of the substrate 100, when the liquid nozzle moves to a certain area above the substrate 100, the on-off valves 501a and 501c on the first and third fluid delivery branch pipe connected to the fluid delivery pipe of a cavity located on the radius of the heating plate corresponding to said certain area are closed, while the on-off valve 501b on the second fluid delivery branch pipe connected to the fluid delivery pipe of the cavity is opened, and the on-off valve 501c on the third fluid delivery branch pipe connected to the fluid delivery pipe of another cavity adjacent to the aforesaid cavity is opened, here, the another cavity is further away from the center of the heating plate than the aforesaid cavity. The fluid in the second fluid delivery main pipe 4062 connected to the aforesaid cavity below the substrate 100 corresponding to the position of the liquid nozzle and the fluid heats the substrate 100 region corresponding to the aforesaid cavity via the fluid outlet holes 4013 to the second temperature; at the same time, the fluid reaching the third thermal energy in the third fluid delivery main pipe 4063 flows through the fluid outlet holes 4013 opened in the another cavity adjacent to the aforesaid cavity to re-preheat the substrate 100 region corresponding to the another cavity to a third temperature.

The third temperature is the temperature of preheating again, and the third temperature is higher than the first temperature, but lower than the second temperature. The third temperature in this embodiment is set to be less than the temperature of liquid boiling point, taking IPA as an example, preferred temperature range is 70-78° C.

By setting three fluid delivery main pipes 4061, 4062, 4063, the fluid inside the three fluid delivery main pipes 4061, 4062, 4063 has different thermal energy. The fluid inside the three fluid delivery main pipes 4061, 4062, 4063 are already heated inside the fluid delivery main pipes. When delivering the fluid to the respective fluid delivery pipes, there is no need to heat the fluid again in the fluid delivery pipes, avoiding situations that may affect the precise control of the temperature in the target region. The first fluid delivery main pipe 4061 provides fluid to preheat the substrate 100. The third fluid delivery main pipe 4063 provides fluid at a temperature higher than that delivered by the first fluid delivery main pipe 4061 for re-preheating the substrate 100. The second fluid delivery main pipe 4062 provides fluid that can make the temperature of the liquid dispensed by the liquid nozzle reach a temperature near the boiling point of the liquid, which can rapidly heat the substrate 100 after the liquid is dispensed on the substrate 100, achieving the purpose of rapid drying. It is worth noting that the fluid for re-preheating in the third fluid delivery main pipe 4063is supplied to another cavity adjacent to the cavity below the substrate 100 region corresponding to the liquid nozzle, and the another cavity is further away from the center of the heating plate than the cavity below the substrate 100 region corresponding to the liquid nozzle in the radial direction.

For more specific details, please refer to Fig. 7. When the liquid nozzle moves above the substrate 100 region corresponding to the cavity 40111, the substrate 100 is driven to rotate by the rotary drive mechanism 300, and the liquid nozzle dispenses liquid to the annular or circular region. When the cavity 40111 is fan-shaped, the region corresponding to the liquid dispensed by the liquid nozzle is a circular region. When the cavity 40111 is arc-shaped, the region corresponding to the liquid dispensed by the liquid nozzle is an annular region. At this point, the opening and closing status of the on-off valves on the fluid delivery branch pipes connected to the cavity 40111 is as follows: the on-off valve 501a on the first fluid delivery branch pipe connected to the first fluid delivery main pipe 4061 is closed; the on-off valve 501b on the second fluid delivery branch pipe connected to the second fluid delivery main pipe 4062 is open for supplying the fluid with the second temperature to the cavity 40111; the on-off valve 501c on the third fluid delivery branch pipe connected to the third fluid delivery main pipe 4063 is closed. At the same time, in the radial direction gradually away from the center of the heating plate, the opening and closing status of the on-off valves on the fluid delivery branch pipes connected to the cavity 40112 adjacent to the cavity 40111 is as follows: the on-off valve 501a on the first fluid delivery branch pipe connected to the first fluid delivery main pipe 4061 is closed, the on-off valve 501b on the second fluid delivery branch pipe connected to the second fluid delivery main pipe 4062 is closed, the on-off valve 501c on the third fluid delivery branch pipe connected to the third fluid delivery main pipe 4063 is open for supplying the fluid with the third thermal energy to the cavity 40112. When the liquid nozzle continues to move towards the edge of the substrate and leaves the cavity 40111, reaching the cavity 40112, the opening and closing status of the on-off valves on the fluid delivery branch pipes connected to the cavity 40112 is as follows: the on-off valve 501a on the first fluid delivery branch pipe connected to the first fluid delivery main pipe 4061 is closed; the on-off valve 501b on the second fluid delivery branch pipe connected to the second fluid delivery main pipe 4062 is open for supplying the fluid with the second thermal energy to the cavity 40112; the on-off valve 501c on the third fluid delivery branch pipe connected to the third fluid delivery main pipe 40631 is closed. At the same time, in the radial direction gradually away from the center of the heating plate, the cavity 40113 adjacent to the cavity 40112 is supplied fluid with the third thermal energy, and so on, until the liquid nozzle moves to the edge of the substrate 100, completing the heating and drying process.

Furthermore, the fluid delivery main pipe can include four fluid delivery main pipes or five fluid delivery main pipes, etc., according to actual needs, to meet the target requirements for more precise control of the drying temperature of substrate 100. For example, when there are four fluid delivery main pipes, each fluid delivery pipe is connected to four fluid delivery branch pipes and an on-off valve is set on each fluid delivery branch pipe. When the liquid nozzle moves above the substrate 100 region corresponding to the cavity 40111 and dispenses liquid to the substrate 100, the opening and closing status of the on-off valves on the fluid delivery branch pipes connected to the cavity 40111 is as follows: the on-off valve on the first fluid delivery branch pipe connected to the first fluid delivery main pipe is closed; the on-off valve on the second fluid delivery branch pipe connected to the second fluid delivery main pipe is open for supplying fluid with the second thermal energy to the cavity 40111; the on-off valve on the third fluid delivery branch pipe connected to the third fluid delivery main pipe is closed; and the on-off valve on the fourth fluid delivery branch pipe connected to the fourth fluid delivery main pipe is closed. At the same time, in the radial direction gradually away from the center of the heating plate, the opening and closing status of the on-off valves on the fluid delivery branch pipes connected to the cavity 40112 adjacent to the cavity 40111 is as follows: the on-off valve on the first fluid delivery branch pipe connected to the first fluid delivery main pipe is closed; the on-off valve on the second fluid delivery branch pipe connected to the second fluid delivery main pipe is closed; the on-off valve on the third fluid delivery branch pipe connected to the third fluid delivery main pipe is open for supplying fluid with the third thermal energy to the cavity 40112; and the on-off valve on the fourth fluid delivery branch pipe connected to the fourth fluid delivery main pipe is closed. At the same time, in the radial direction gradually away from the center of the heating plate, the opening and closing status of the on-off valves on the fluid delivery branch pipes connected to the cavity 40113 adjacent to the cavity 40112 is as follows: the on-off valve on the first fluid delivery branch pipe connected to the first fluid delivery main pipe is closed; the on-off valve on the second fluid delivery branch pipe connected to the second fluid delivery main pipe is closed; the on-off valve on the third fluid delivery branch pipe connected to the third fluid delivery main pipe is closed; and the on-off valve on the fourth fluid delivery branch pipe connected to the fourth fluid delivery main pipe is open for supplying fluid with a fourth thermal energy to the cavity 40113. The first temperature is holding temperature. The second temperature is about the temperature at which the liquid dispensed to the substrate 100 by the liquid nozzle reaches its boiling point. The third temperature and the fourth temperature are the preheating temperatures. The third temperature and the fourth temperature can be the same or different, but both need to be higher than the first temperature and lower than the second temperature. Setting the preheating temperature below the boiling point temperature is to ensure that the liquid in that region is not boiling before the liquid nozzle reaches that region.

A substrate processing method comprises: holding a substrate on a clamp mechanism; driving the clamp mechanism to rotate the substrate; dispensing liquid onto the surface of the substrate through a liquid nozzle of a spray head mechanism, wherein during the process of the liquid nozzle moving radially from the center of the substrate towards the edge of the substrate, when the liquid nozzle moves to a certain area above the substrate, heating a substrate region of which radius is the same as said certain area on the substrate by jetting fluid with second thermal energy to the bottom of the substrate, thereby increasing the local temperature of the substrate under the liquid nozzle.

Furthermore, before dispensing the liquid to the surface of the substrate through the liquid nozzle of the spray head mechanism, the method further includes: jetting fluid with first thermal energy to the whole bottom of the substrate to preheat the whole substrate.

Furthermore, while heating a substrate region of which radius is the same as said certain area on the substrate by jetting fluid with second thermal energy to the bottom of the substrate, re-preheating another region of the substrate adjacent to the substrate region of which radius is the same as said certain area on the substrate by jetting fluid with third thermal energy to the bottom of the substrate, wherein the another region of the substrate is corresponding to an area adjacent to said certain area in the radial direction.

Furthermore, the fluid is gas or liquid.

Furthermore, by controlling the temperature and/or flow rate of the fluid with the second thermal energy to locally heat the substrate region of which radius is the same as said certain area on the substrate, the local temperature of the substrate under the liquid nozzle is increased.

Furthermore, after the substrate is taken away from the clamp mechanism, the temperature of the heating plate is lowered by supplying low-temperature fluid.

### Embodiment 8

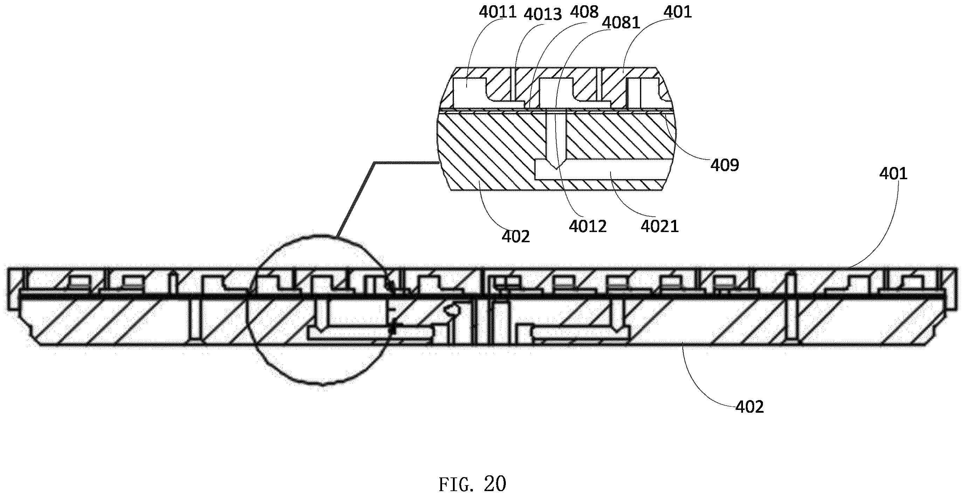

This embodiment provides a substrate processing apparatus, the structure of which is substantially the same as the substrate processing apparatus in Embodiment 1. The difference is that, as shown in Fig. 20, which illustrates a cross-sectional view of the assembly of the first chuck and the second chuck in this embodiment of the present invention. As shown in Fig. 20, a heating element 408 is disposed between the first chuck 401 and the second chuck 402. The heating element 408 is used to heat the fluid in the cavity 4011 and to heat the whole first chuck 401. During the process, depending on the heating requirements, the number of heating elements 408 can be one or more. When the number of heating elements 408 is greater than one, the installation positions and the structural designs of the heating elements 408 can be set according to actual requirements. In this embodiment, mainly describe the situation when the number of heating elements 408 is one. The heating element 408 in this embodiment is a plate-like structure. Communication holes 4081 is set on the heating element 408 and the communication holes 4081 connect the first fluid delivery channel 4021 and the fluid inlet holes 4012. Referring to Fig. 5, when the fluid flows through the second fluid delivery channel 4031 in the shaft body 403 and the first fluid delivery channel 4021 in the second chuck 402 to the cavity 4011 on the first chuck 401, the fluid will pass through the communication hole 4081 on the heating element 408 and the fluid inlet hole 4012 on the first chuck 401, entering the cavity 4011. The heating element 408 directly heats the fluid in the cavity 4011, and at the same time, the position where the heating element 408 with plate-like structure directly contacts the first chuck 401 directly heats the whole first chuck 401 by thermal radiation, making the temperature of the first chuck 401 increase simultaneously. Therefore, when preheating the substrate 100, the preheating effect can be achieved more quickly.

During the process, when the fluid passes through the fluid delivery pipe, the second fluid delivery channel 4031, the first fluid delivery channel 4021 and the fluid inlet hole 4012 to reach the cavity 4011, because each component is at room temperature, but the fluid contains high thermal energy, the temperature of the fluid is higher than that of the components the fluid flows through. Therefore, the fluid will undergo convective heat exchange with the components the fluid flows through, transferring heat to each component, reducing the thermal energy contained in the fluid itself, resulting in insufficient thermal energy in the fluid flowing out of the cavity 4011. When the fluid flows to the substrate 100, the temperature at the corresponding position on the substrate 100 cannot be rapidly raised to the target temperature, leading to the vaporization and drying effect of the liquid on the substrate 100 being affected. The adjacent feature pattern structures may still be pulled by the surface tension of the liquid, potentially causing damage to the feature pattern structures, affecting the yield of the processing of the substrate 100.

In the embodiment of the present invention, the heating element 408 is disposed between the first chuck 401 and the second chuck 402. During the process, after the fluid passes through each fluid delivery pipe, the second fluid delivery channel 4031, the first fluid delivery channel 4021, the fluid flow throughs the fluid inlet hole 4012 on the first chuck 401 into the cavity 4011. The heating element 408 heats the fluid inside the cavity 4011, increasing the thermal energy of the fluid. The thermal energy of the fluid is raised to meet the requirement of rapidly heating the temperature at the corresponding position on the substrate 100 to the target temperature. The fluid then flows out through the fluid outlet holes 4013 opened on the cavity 4011 and flows towards the substrate 100, rapidly heating the substrate 100. The heating element 408 can achieve the effect of secondary heating of the fluid, further ensuring that the temperature at the corresponding position on the substrate 100 is rapidly raised to the target temperature, ensuring that the process of vaporization of the liquid at that position on the substrate 100 is fast enough, and no pull of liquid surface tension between adjacent feature pattern structures, effectively avoiding damage to the fine pattern structures on the surface of substrate 100 during the drying process.

The other structures of this embodiment are the same as that of Embodiment 1.

The substrate processing method corresponding to this embodiment is substantially the same as Embodiment 1. The difference is that in this embodiment, during the process, the control mechanism controls the heater 503 to heat the fluid, and at the same time, the heating element 408 is turned on. The heating temperature of the heating element 408 is pre-set. It should be understood that the heating temperature of the heating element 408 can be set according to the actual process requirements, and is not limited in the present invention. For example, in this exemplary embodiment of the present invention, the heating temperature of the heating element 408 is set to 80°C to prepare for convective heating of the fluid that is about to enter the cavity 4011 inside the first chuck 401.

### Embodiment 9

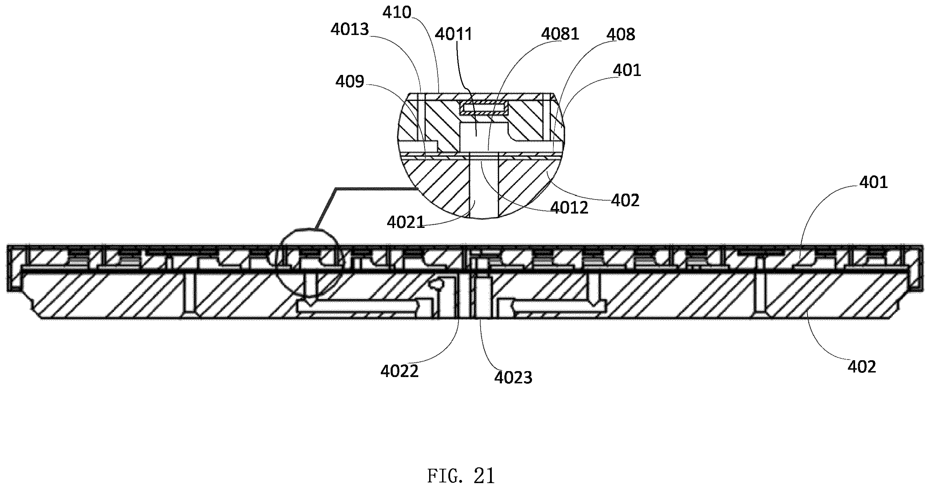

This embodiment provides a substrate processing apparatus, the structure of which is substantially the same as the substrate processing apparatus in Embodiment 8. The difference is that, referring to Fig. 21, showing a cross-sectional view of the assembly of the first chuck and the second chuck of the embodiment of the present invention. As shown in Fig. 21, the substrate processing apparatus further includes a cooling mechanism. The cooling mechanism includes a cooling part set on the first chuck 401. The actual selection of the cooling part includes but not limited to: cooling grooves, cooling cavities, cooling pipes, and various combinations thereof. The specific type can be selected according to the actual process requirements. The cooling part is configured to lower the temperature of the first chuck 401 or the second chuck 402 to avoid affecting the RCA process (chemical standard process) of the next substrate 100 due to high temperature of the first chuck 401 or the second chuck 402 after the end of the current process operation.

When the cooling part is configured to reduce the temperature of the first chuck 401, during the cooling process, the ways in which the cooling part is set include but not limited to the following ways:

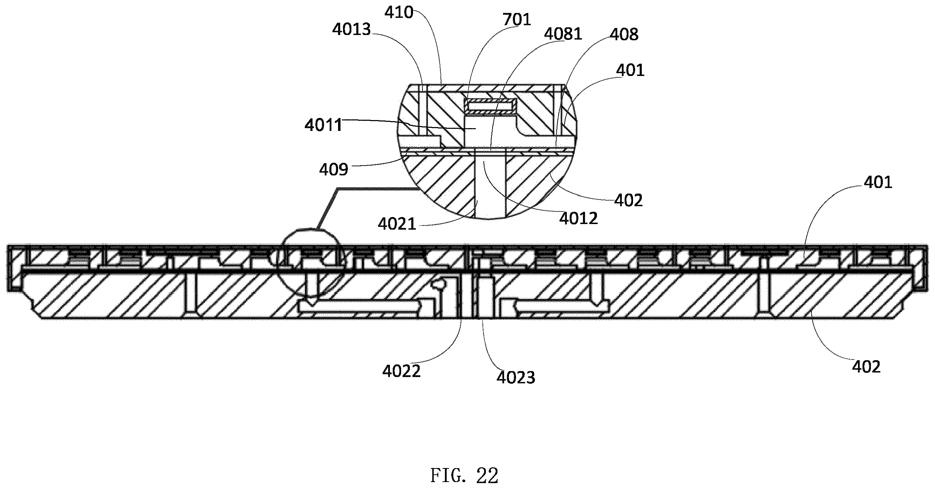

The first way, the cooling part 701 is a cooling pipe. Please refer to Fig. 22. Fig. 22 shows a schematic view of the structure while the cooling part is a cooling pipe and is located inside the first chuck in an embodiment of the present invention. As shown in Fig. 22, the cooling part 701 is embedded inside the first chuck 401. Furthermore, an accommodating cavity is disposed around each cavity 4011 of the first chuck 401, and the cooling part 701 is set inside the accommodating cavity.

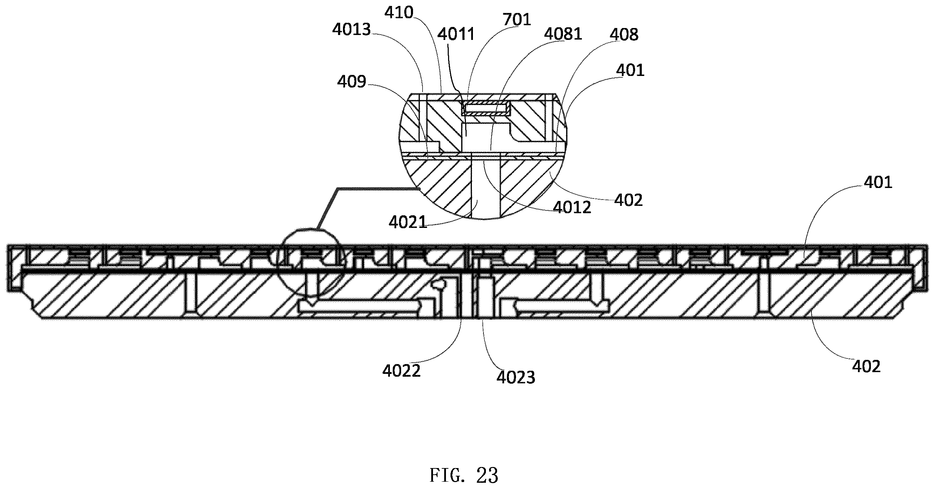

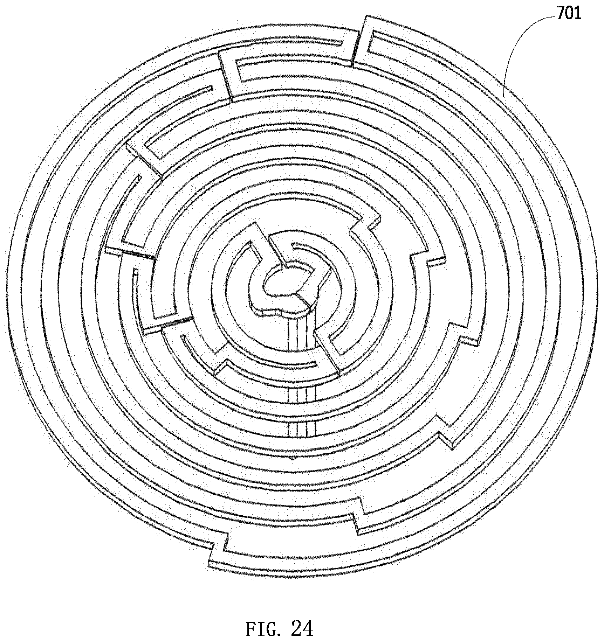

The second way, the cooling part 701 is a cooling pipe. Please refer to Fig. 23. Fig. 23 shows a schematic view of the structure while the cooling part is a cooling pipe and is located on the upper surface of the first chuck in an embodiment of the present invention. As shown in Fig. 23, the cooling part 701 is set on the upper surface of the first chuck 401, and a cooling part 701 is correspondingly set above each cavity 4011. Specifically, an accommodating groove is opened on the upper surface of the first chuck 401, and the cooling part 701 is set in the accommodating groove. At the same time, a sealing layer 410 is set on the upper surface of the first chuck 401. After the cooling parts 701 are placed in the accommodating grooves, the sealing layer 410 is fixedly connected to the first chuck 401 to seal the opening end of the accommodating grooves. In the actual design process, the number and shape of the cooling part 701 can be selected according to actual needs. In this embodiment of the present invention, the cooling pipes set in the areas corresponding to the cavities 4011 are the same cooling pipe. Please refer to Fig. 24 for the specific structure. Fig. 24 shows a schematic view of the structure of the cooling pipe in an embodiment of the present invention. As shown in Fig. 24, the cooling pipe has a coiled structure.

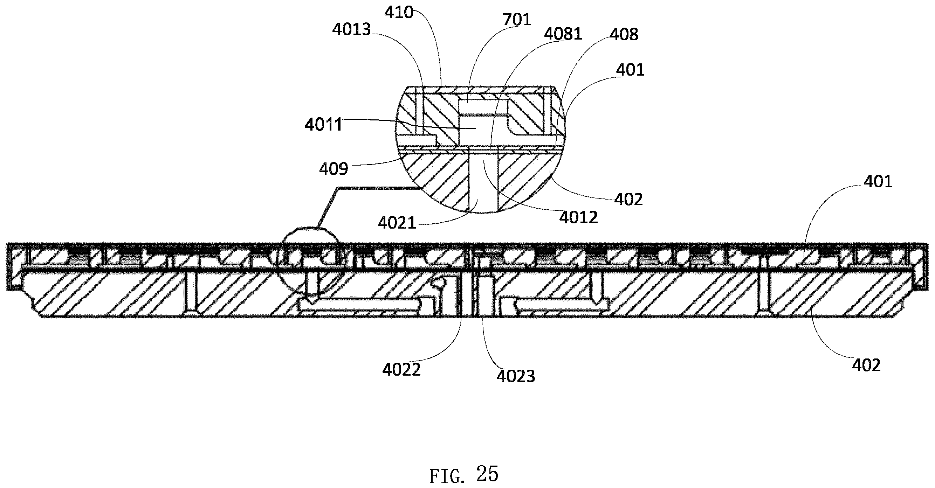

The third way, please refer to Fig. 25. Fig. 25 shows a schematic view of the structure while the cooling part is a cooling cavity in an embodiment of the present invention. As shown in Fig. 25, when the cooling part 701 is a cooling cavity, and the cooling cavity is disposed inside the first chuck 401. It can be understood that this way is the first way removing the cooling pipe from the accommodating cavity, and the cooling cavity directly serves as the cooling part 701.

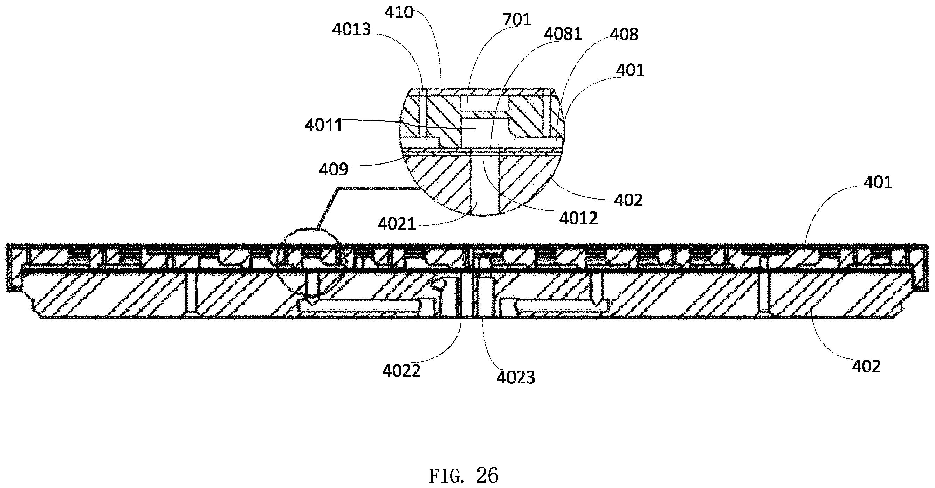

The fourth way, please refer to Fig. 26, which shows a schematic view of the structure of the cooling part being a cooling groove in an embodiment of the present invention. As shown in Fig. 26, when the cooling part 701 is a cooling groove, the cooling groove is opened at the upper surface of the first chuck 401. Similarly, a sealing layer 410 is set on the upper surface of the first chuck 401, and the sealing layer 410 is fixedly connected to the first chuck 401 to seal the opening ends of the cooling grooves. It can be understood that this way is the second way removing the cooling pipe from the accommodating groove, and the cooling groove directly serves as the cooling part 701.

Furthermore, a protective layer is coated on the first chuck 401, and the sealing layer 410 set on the upper surface of the first chuck 401 can also serve as a protective layer. For example, when the cooling part 701 is designed as the second or fourth way mentioned above, the sealing layer 410 serves as a protective layer, the sealing layer 410 is made of a corrosion-resistant, high-temperature resistant, and good thermal insulation material, such as Teflon. The sealing layer 410 made of Teflon can prevent chemical solutions from corroding the first chuck 401 during the process. When the cooling part 701 is designed as the second or fourth way mentioned above, and the sealing layer 410 and the protective layer are independently set, the protective layer covers the upper surface and side surfaces of the sealing layer 410, and the outer surface of the first chuck 401. In this embodiment, Teflon material, which is corrosion-resistant, high-temperature resistant, and good thermal insulation, is still used as the protective layer. When the cooling part 701 is designed as the first or third way mentioned above, since the sealing layer 410 is not set, the protective layer covers the outer surface of the first chuck 401. In this embodiment, Teflon material, which is corrosion-resistant, high-temperature resistant, and good thermal insulation, is still used as the protective layer. The setting of the protective layer can help to isolate heat within the heating plate.

By choosing the third and fourth ways as the cooling part, the cooling pipe is eliminated, and the designs of the cooling groove and cooling cavity are directly carried out on the first chuck 401. This makes the preparation of the apparatus simpler and more cost-effective.

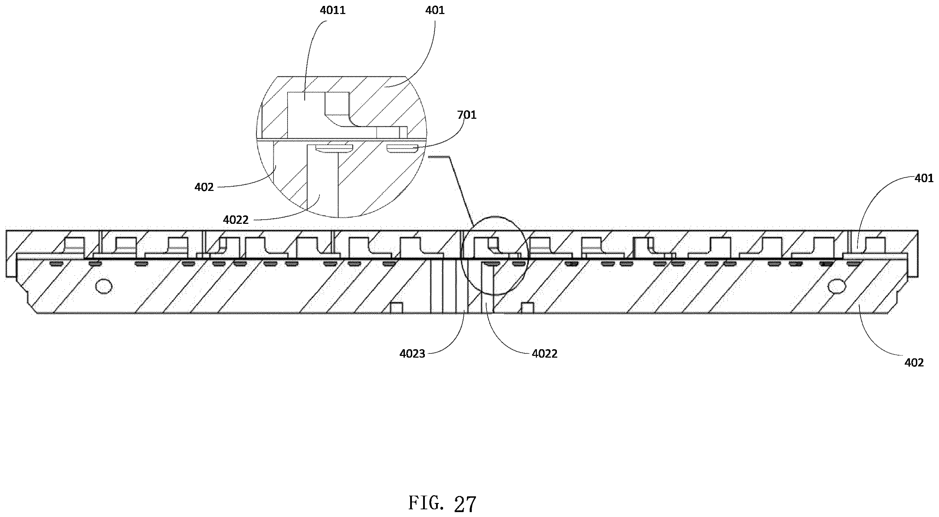

When the cooling part 701 is configured to lower the temperature of the second chuck 402, the second way mentioned above can be adopted, that is, the cooling part 701 is a cooling pipe directly embedded inside the second chuck 402, or the third way, a cooling cavity is disposed inside the second chuck 402, which serves as the cooling part 701. Considering the convenience of operation in actual processes, in this embodiment, a cooling cavity is disposed inside the second chuck 402. As shown in Fig. 27, Fig. 27 illustrates an exemplary schematic view of the cooling mechanism cooling the second chuck according to an embodiment of the present invention.

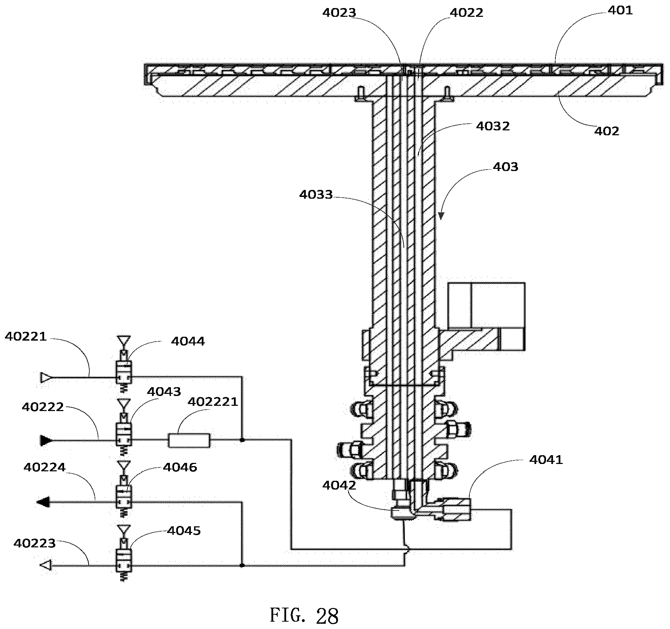

Please refer to Fig. 28, which shows an exemplary schematic view of the cooling mechanism cooling the first chuck according to an embodiment of the present invention. As shown in Fig. 28, in conjunction with Fig. 22 or Fig. 23 or Fig. 25 or Fig. 26 or Fig. 27, an inlet of the cooling part 701 is connected to a cooling liquid inlet 4022 opened on the second chuck 402, and the cooling liquid inlet 4022 is connected to the third fluid delivery channel 4032 disposed in the shaft body 403. An outlet of the cooling part 701 is connected to a cooling liquid outlet 4023 opened on the second chuck 402, and the cooling liquid outlet 4023 is connected to the fourth fluid delivery channel 4033 disposed in the shaft body 403. At the bottom of the shaft body 403, there is a connector 4041 connected to the third fluid delivery channel 4032 and a connector 4042 connected to the fourth fluid delivery channel 4033.

In one embodiment, the inlet of the cooling part 701 is connected to a delivery pipe, which passes through the cooling liquid inlet 4022 opened on the second chuck 402, the third fluid delivery channel 4032 in the shaft body 403, and reaches the outside to connect with the connector 4041. The outlet of the cooling part 701 is connected to a delivery pipe, which passes through the cooling liquid outlet 4023 opened on the second chuck 402, the fourth fluid delivery channel 4033 in the shaft body 403, and reaches the outside to connect with the connector 4042.

The connector 4041 connected to the third fluid delivery channel 4032 is connected to at least one inlet pipe for delivering liquid into the cooling part 701. In this embodiment of the present invention, the connector 4041 is chosen to connect one inlet pipe 40222 for delivering liquid into the cooling part 701, and the number of inlet pipes connected to the connector 4041 for delivering liquid into the cooling part 701 can be selected according to needs. The inlet pipe for delivering liquid into the cooling part 701 is equipped with a cooler 402221 for cooling the liquid flowing through the inlet pipe. The connector 4042 connected to the fourth fluid delivery channel 4033 is connected to at least one outlet pipe for discharging the liquid from the cooling part 701. In this embodiment of the present invention, the connector 4042 is chosen to connect one outlet pipe 40224 for discharging the liquid from the cooling part 701. An on-off valve is installed on each of the inlet pipe 40222 and the outlet pipe 40224, which is configured to open or close the flow of liquid through the inlet pipe 40222 and the outlet pipe 40224. As shown in Fig. 28, in this embodiment of the present invention, an on-off valve 4043 is installed on the inlet pipe 40222, and an on-off valve 4046 is installed on the outlet pipe 40224.

Furthermore, the connector 4041 connected to the third fluid delivery channel 4032 is connected to at least one inlet gas pipe for delivering gas into the cooling part 701. In this embodiment of the present invention, the connector 4041 is set to connect one inlet gas pipe 40221 for delivering gas into the cooling part 701, and the number of inlet gas pipes for delivering gas into the cooling part 701 can be selected according to actual needs. The connector 4042 connected to the fourth fluid delivery channel 4033 is connected to at least one outlet gas pipe for discharging gas from the cooling part 701. In this embodiment of the present invention, the connector 4042 is connected to one outlet gas pipe 40223 for discharging gas from the cooling part 701. Similarly, an on-off valve is installed on each of the inlet gas pipe 40221 and the outlet gas pipe 40223 to open or close the flow of gas through the inlet gas pipe 40221 and the outlet gas pipe 40223. As shown in Fig. 28, in this embodiment of the present invention, an on-off valve 4044 is installed on the inlet gas pipe 40221, and an on-off valve 4045 is installed on the outlet gas pipe 40223.

In one embodiment, the manufacturing material of the first chuck 401 is metal. In this exemplary embodiment, the choices for the manufacturing material of the first chuck 401 include but not limited to Hastelloy, aluminum alloy, and nickel-based alloy. Because the first chuck 401 is made of metal material, it has the characteristics of good thermal conductivity, fast heat dissipation, the sealing layer 410 having good heat insulation performance and the corrosion-resistant can prevent the first chuck 401 from dissipating heat too quickly during the process to affect the heating effect of the fluid on the substrate 100. The manufacturing material of the second chuck 402 is non-metal. In this exemplary embodiment, the choices for the manufacturing material of the second chuck 402 include high-temperature resistant and corrosion-resistant plastics, such as PEEK and Teflon. According to the characteristics of different materials with different thermal conductivity and thermal expansion coefficient, the manufacturing material of the first chuck 401 uses metal material with high thermal conductivity and low thermal expansion coefficient, while the manufacturing material of the second chuck 402 uses non-metal material with low thermal conductivity.

After the drying process of the hot fluid on the substrate 100 is completed, the temperature of the first chuck 401 is too high, which can easily affect the drying of the next substrate 100. The cooling mechanism in the present invention has a good cooling effect on the first chuck 401 after the drying process.

In another embodiment, the manufacturing material of the first chuck 401 is non-metal. In this exemplary embodiment, the choices for the manufacturing material of the first chuck 401 include high-temperature resistant and corrosion-resistant plastics, such as PEEK and Teflon. The manufacturing material of the second chuck 402 is metal. In this exemplary embodiment, the choices for the manufacturing material of the second chuck 402 include aluminum alloy, Hastelloy, nickel-based alloy, and so on. Based on the characteristics of different materials having different thermal conductivity and thermal expansion coefficients, in this embodiment of the present invention, the manufacturing material of the first chuck 401 uses non-metal with low thermal conductivity to ensure minimal heat loss when the fluid passes through the first chuck 401. Simultaneously, it can avoid the impact of high temperature of the first chuck 401 on the RCA process (chemical standard process) of the next substrate 100 after the completion of this process operation. The manufacturing material of the second chuck 402 uses metal with a low thermal expansion coefficient to ensure that the second chuck 402 is not easily deformed when the hot fluid passes through it. The first chuck 401 and the second chuck 402 support each other, with the low thermal expansion coefficient of the second chuck 402 also provides support to the first chuck 401, preventing deformation of the first chuck 401.

Furthermore, referring to Fig. 25 and Fig. 26, a thermal insulation layer 409 is set between the second chuck 402 and the heating element 408. By setting the thermal insulation layer 409, the heat from the heating element 408 is isolated above the second chuck 402, in order to maximize the heat used for heating the fluid inside the cavity 4011.

Furthermore, in the embodiment of the present invention, the outer surface of the second chuck 402 is coated with a corrosion-resistant layer to prevent chemical solutions and process environment from corroding the second chuck 402 made of metal material during the process, thus protecting the apparatus. For example, a Teflon coating is selected for the corrosion-resistant layer.

The other structures of this embodiment are the same as that of Embodiment 8.

The substrate processing method corresponding to this embodiment is substantially the same as that of Embodiment 8. The difference is that the control mechanism in this embodiment is also configured to control the cooling mechanism to cool the first chuck 401 or the second chuck 402.

Specifically, after the process of heating and drying of the substrate 100 is completed, the control mechanism opens the on-off valves 4043 and 4046 on the inlet pipe 40222 and the outlet pipe 40224 that are connected to the inlet and the outlet of the cooling part 701. The cooler 402221 is controlled to cool the temperature of the liquid flowing through the inlet pipe 40222 to a low temperature, where the low temperature in this embodiment of the present invention refers to a temperature range below 20°C. The cooled low-temperature liquid enters the cooling part 701 through the third fluid delivery channel 4032 in the shaft body403, the cooling liquid inlet 4022, and the inlet of the cooling part 701 to perform cooling treatment on the first chuck 401 or the second chuck 402. Subsequently, the liquid flows out of the cooling part 701 through the outlet of the cooling part 701, the cooling liquid outlet 4023, and the fourth fluid delivery channel 4033 in the shaft body 403, and is discharged through the outlet pipe 40224 connected to the outlet of the cooling part 701. The time period for supplying the low-temperature liquid is T1, which reduces the overall temperature of the first chuck 401 or the second chuck 402 to room temperature. Then, the cooler 402221 is closed, and the on-off valves 4043 and 4046 are closed.

Furthermore, when the overall temperature of the first chuck 401 or the second chuck 402 has decreased to room temperature, after closing the cooler 402221 and the on-off valves 4043, 4046, the control mechanism opens the on-off valves 4044 and 4045 on the inlet gas pipe 40221 and the outlet gas pipe 40223. The gas enters the cooling part 701 through the third fluid delivery channel 4032 in the shaft body 403, the cooling liquid inlet 4022, and the inlet of the cooling part 701, and then flows out of the cooling part 701 through the outlet of the cooling part 701, the cooling liquid outlet 4023, and the fourth fluid delivery channel 4033 in the shaft body 403, and is discharged through the outlet gas pipe 40223 connected to the outlet of the cooling part 701. The gas flows through the interior of the cooling part 701 for a time period T2 to dry the interior of the cooling part 701. Preferably, to accelerate the drying process, dry gas is selected as the gas supplied into the cooling part 701 for drying.

After processing the cooling mechanism for the time T1 and the time T2, while the first chuck 401 or the second chuck 402 quickly returns to room temperature, the internal environment of the cooling part 701 also returns to a dry state.

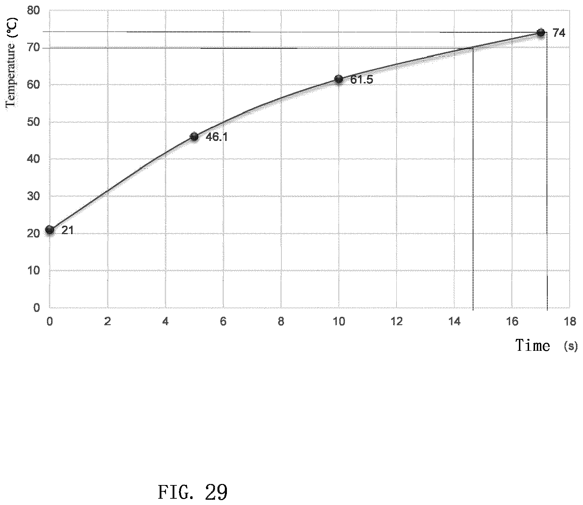

As described above, in one embodiment of the drying process, under the conditions of setting the rotation speed of the substrate 100 being 1100 rpm, the flow rate of the fluid with first thermal energy being 280 L, and the temperature of the fluid with first thermal energy is 80°C, the substrate processing method provided by the present invention is used for processing a substrate. Please refer to Fig. 29 for experimental results. Fig. 29 illustrates the temperature curve change of preheating the substrate using the fluid with first thermal energy in the embodiment of the present invention. As shown in Fig. 29, through simulation experiments, the temperature of the substrate 100 surface can reach 70°C from room temperature within 15 seconds through the preheating treatment with the fluid reaching the first thermal energy.

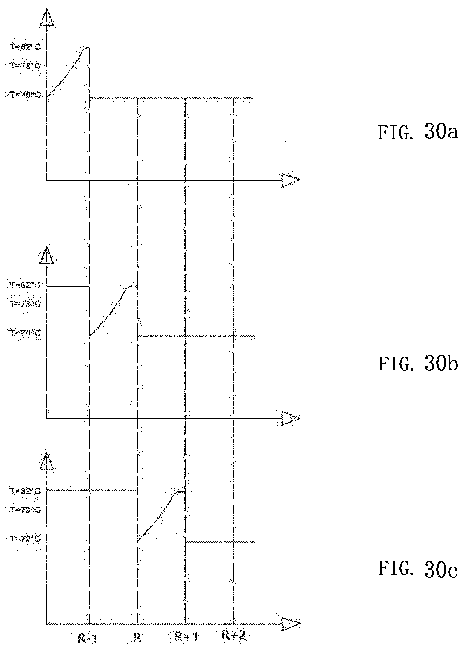

Figs. 30a to 30c illustrate the temperature variation curves of different regions of the substrate as the liquid nozzle moves when the substrate is processed according to the substrate processing methods of Embodiment 1, Embodiment 4, and Embodiment 5 of the present invention. Combining with Figs. 15, 16, 17, and Figs. 30a to 30c, in one embodiment, taking IPA as an example for drying fluid, dry processing of substrate 100 is carried out using the methods of Embodiments 1, 4, and 5. one of the cavities 4011 on the first chuck 401 is numbered R. The cavity adjacent to R on the side closer to the center of the first chuck 401 in the radial direction is numbered R-1, and the cavity adjacent to R on the side closer to the edge of the first chuck 401 is numbered R+1. The cavity adjacent to R+1 is designated as R+2. Here, R is a positive integer greater than or equal to 1. When R is equal to 1, it indicates that the liquid nozzle is positioned at the center of the substrate 100. When the liquid nozzle moves directly above the center of the substrate 100, before dispensing liquid to the surface of the substrate 100, the control mechanism controls the heater 503 to heat the fluid passing through the fluid delivery pipe to the first thermal energy. The fluid reaching the first thermal energy passes through the fluid outlet holes 4013 of each cavity 4011 to heat the substrate 100 to the first temperature. The first temperature is the preheating temperature, and the preheating temperature is 70 ° C in this embodiment. Combining with the data results of the experiment shown in Fig. 29, the surface of the substrate 100 can reach 70 ° C from room temperature within 15 seconds, and the preheating of the substrate 100 is completed.

During the movement of the liquid nozzle from the center of substrate 100 to the edge of substrate 100 along the radial direction of substrate 100, when the liquid nozzle moves to a certain area above the substrate 100, the control mechanism controls the heater 503 to heat the fluid in the cavity 4011 numbered R-1 to second thermal energy, wherein the cavity 4011 numbered R-1 is located at the radius corresponding to said certain area. The fluid with the second thermal energy flows through the fluid outlet holes 4013 of the cavity 4011 numbered R-1 to heat the substrate 100 region corresponding to said certain area to second temperature. The second temperature of the process is 82°C, and the temperature of the substrate 100 region corresponding to said certain area rises rapidly from 70°C to 82°C. As shown in Fig. 30a, at this time, in the radial direction away from the cavity 4011 numbered R-1, the temperatures of the cavities with the numbers R, R+1, and R+2 still remain in the preheated state at 70°C. When the liquid nozzle moves to the next area adjacent to said certain area in the radial direction above the substrate 100, that is, when the liquid nozzle moves to the area above the substrate 100 corresponding to the cavity 4011 numbered R, the control mechanism controls the heater 503 to heat the fluid in the cavity 4011 numbered R to the second thermal energy. The fluid with the second thermal energy flows through the fluid outlet holes 4013 of the cavity 4011 numbered R to heat the substrate 100 region corresponding to the area adjacent to said certain area to the second temperature. The second temperature is 82°C, and the temperature of the substrate 100 region corresponding to the area adjacent to said certain area rises rapidly from 70°C to 82°C, and so on, until the entire surface of the substrate 100 is treated.

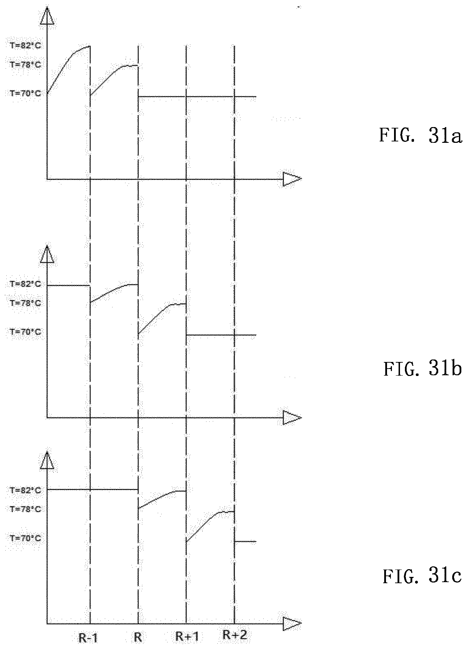

In another embodiment, taking IPA as an example for the drying fluid, when drying the substrate 100 using the substrate processing method of Embodiment 7, please refer to Fig. 19 and Figs. 31a to 31c. Figs. 31a to 31c illustrate the temperature variation curves of different regions of the substrate as the liquid nozzle moves when the substrate is processed according to the substrate processing method of Embodiment 7 of the present invention. Similarly, one of the cavities 4011 on the first chuck 401 is numbered R, then in the radial direction of the first chuck 401, the cavity 4011 adjacent to R on the side closer to the center of the first chuck 401 is numbered R-1, the cavity 4011 adjacent to R on the side closer to the edge of the first chuck 401 is numbered R+1, and the cavity 4011 adjacent to R+1 is numbered R+2. The control mechanism controls the heater 503a to heat the fluid flowing through the first fluid delivery main pipe 4061, and the heated fluid heats the substrate 100 to first temperature through the fluid outlet holes 4013 of each cavity, completing the preheating of the substrate 100. The first temperature is 70° C.

In the subsequent substrate processing, during the movement of the liquid nozzle from the center of the substrate 100 to the edge of the substrate 100 along the radial direction of substrate 100, when the liquid nozzle moves to a certain area above the substrate 100, the on-off valve 501a on the first fluid delivery branch pipe connected to the fluid delivery pipe connected to the cavity 4011 numbered R-1 on the radius of the heating plate corresponding to said certain area is closed, and the on-off valve 501c on the third fluid delivery branch pipe is closed, at the same time, the on-off valve 501b on the second fluid delivery branch pipe connected to the cavity 4011 numbered R-1 is opened. Simultaneously, the on-off valve 501c on the third fluid delivery branch pipe connected to the cavity 4011 numbered R is opened, while the on-off valves 501a and 501b on the first and second fluid delivery branch pipes are closed. Controlling the fluid in the second fluid delivery main pipe 4062 connected to the cavity beneath the substrate 100 corresponding to the position of the liquid nozzle, the fluid heats the substrate 100 region corresponding to the cavity 4011 numbered R-1 to the second temperature, i.e., 82°C, through the fluid outlet holes 4013 of the cavity 4011 numbered R-1. The temperature variation curve of the substrate 100 region corresponding to the cavity 4011 numbered R-1 during this process is shown in Fig. 31a. At the same time, the fluid with the third thermal energy in the third fluid delivery main pipe 4063 re-preheats the substrate 100 region corresponding to the cavity 4011 numbered R to third temperature, i.e., 78°C through the fluid outlet holes 4013 of the cavity 4011 numbered R. The temperature variation curve of the substrate 100 region corresponding to the cavity 4011 numbered R during this process is shown in Fig. 31b. As shown in Figs. 31a, 31b, and 31c, at this point, the temperature status of the cavity numbered R is re-preheated to 78°C; while the temperature status of the cavity numbered R + 1 and the cavity numbered R+2 still maintains the preheated state at 70°C. As the liquid nozzle continues to move to the next area adjacent to said certain area above the substrate 100, that is, when the liquid nozzle moves to the area above the substrate 100 corresponding to the cavity 4011 numbered R, the control mechanism controls the on-off valve 501a on the first fluid delivery branch pipe connected to the cavity numbered R to be closed, and controls the on-off valve 501c on the third fluid delivery branch pipe connected to the cavity numbered R to be closed. The control mechanism controls the on-off valve 501b on the second fluid delivery branch pipe connected to the cavity numbered R to be opened, allowing the fluid with the second thermal energy to heat the substrate 100 region corresponding to the cavity numbered R to second temperature, which is 82°C. The temperature of the substrate 100 region corresponding to the cavity numbered R rapidly rises from 78°C to 82 °C ; meanwhile, the substrate 100 region corresponding to the cavity 4011 numbered R+1 is in a re-preheated state at 78°C. At this point, the on-off valves 501a and 501c respectively on the first and third fluid delivery branch pipes connected to the cavity numbered R+1 are both closed, and the on-off valve 501b on the second fluid delivery branch pipe is open, making the temperature of the substrate 100 region corresponding to the cavity numbered R+1 to quickly rise from 70°C to 78°C. And so on until the entire surface of the substrate 100 is processed. R is a positive integer greater than or equal to 1. When R equals 1, it indicates that the liquid nozzle is located above the center of the substrate 100. When the liquid nozzle is above the center of the substrate 100, it is possible to choose the cavity 4011 closest to the center of the substrate 100 to preheat again, or directly heat it to the second temperature, since the range of the central region of the substrate 100 is small, and the difference in the results of the two processing methods is also small, which will not significantly affect the process results.

Although the present invention has been described in detail with reference to the foregoing embodiments, those of ordinary skill in the art should understand that: it is still possible to modify the technical solutions described in the foregoing embodiments, or perform equivalent replacements for some or all of the technical features; and these modifications or substitutions do not make the essence of the corresponding technical solutions out of the scope of the technical solutions of each embodiment of the present invention.

## Claims

1. A substrate processing apparatus, comprising:
a control mechanism;
a clamp mechanism, configured to hold the substrate;
a spray head mechanism, including a liquid nozzle configured to dispense liquid to a surface of the substrate positioned on the clamp mechanism;
a rotary drive mechanism, configured to drive the clamp mechanism to rotate;
a heating mechanism, including a heating plate arranged under the substrate, the heating plate having at least two cavities along the radial direction, and each cavity being distributed on a different radius, the bottom of each cavity being provided with a fluid inlet hole, and the top of each cavity being provided with fluid outlet holes, the fluid inlet hole being connected to a fluid delivery pipe;
wherein during the process of the liquid nozzle moving from the center of the substrate to the edge of the substrate along the radial direction of the substrate, when the liquid nozzle moves to a certain area above the substrate, the control mechanism controls the thermal energy of the fluid in a cavity on the radius corresponding to said certain area, thereby increasing the local temperature of the substrate under the liquid nozzle.

2. The substrate processing apparatus according to claim 1, wherein the heating mechanism further includes a fluid delivery unit and a heater set on the fluid delivery unit to heat the fluid in the fluid delivery unit.

3. The substrate processing apparatus according to claim 1, wherein the heating plate includes a first chuck and a second chuck, wherein the first chuck is positioned above the second chuck, and the second chuck is matched with the first chuck;
wherein the first chuck has the at least two cavities in the radial direction, and the cavities are respectively distributed at different radii along the radial direction of the first chuck, the bottom of each cavity is provided with the fluid inlet hole, and the top of each cavity is provided with the fluid outlet holes;
the interior of the second chuck is provided with first fluid delivery channels equal to the number of cavities, the first fluid delivery channels are connected to the cavities through the fluid inlet holes.

4. The substrate processing apparatus according to claim 3, wherein the heating plate is evenly divided into n equal parts according to angle, where n is an integer greater than or equal to 2.

5. The substrate processing apparatus according to claim 4, wherein the number of cavities in each equal part is equal, and the cavities are distributed on different radii.

6. The substrate processing apparatus according to claim 1, wherein the at least two cavities are circular in shape and arranged in concentric circles.

7. The substrate processing apparatus according to claim 1, wherein the fluid flowing through the cavities is gas or liquid.

8. The substrate processing apparatus according to claim 1, wherein the density of the fluid outlet holes opened on each cavity of the heating plate is the same.

9. The substrate processing apparatus according to claim 1, wherein the fluid delivery pipes connected to each cavity are respectively connected to the same fluid delivery main pipe, an on-off valve and a heater are respectively installed on each fluid delivery pipe, a mass flow controller is installed on the fluid delivery main pipe;
the on-off valve is configured to open or close the fluid flowing through the fluid delivery pipe;
the mass flow controller is configured to monitor and adjust the flow rate of fluid passing through the fluid delivery main pipe;
the heater is configured to heat the fluid in each fluid delivery pipe.

10. The substrate processing apparatus according to claim 9, wherein the control mechanism is configured to:
open the on-off valves;
control the heater to heat the thermal energy of the fluid passing through the fluid delivery pipe to a first thermal energy, the fluid with the first thermal energy heats the substrate to a first temperature through the fluid outlet holes of each cavity;
during the process of the liquid nozzle moving from the center of the substrate to the edge of the substrate along the radial direction of the substrate, when the liquid nozzle moves to a certain area above the substrate, control the heater to heat the fluid in the cavity on the radius corresponding to said certain area to a second thermal energy, the fluid with the second thermal energy heats the substrate region corresponding to said certain area to a second temperature through the fluid outlet holes of the cavity on the radius corresponding to said certain area.

11. The substrate processing apparatus according to claim 1, wherein each fluid delivery pipe connected to each cavity is equipped with an on-off valve, a mass flow controller, and a heater; wherein,
the on-off valve is configured to open or close the fluid passing through the fluid delivery pipe;
the mass flow controller is configured to monitor and adjust the flow rate of fluid passing through each fluid delivery pipe;
the heater is configured to heat the fluid in the fluid delivery pipe.

12. The substrate processing apparatus according to claim 11, wherein the control mechanism is configured to:
open the on-off valves;
control the heater to heat the thermal energy of the fluid passing through the fluid delivery pipe to a first thermal energy, the fluid with the first thermal energy heats the substrate to a first temperature through the fluid outlet holes of each cavity;
during the process of the liquid nozzle moving from the center of the substrate to the edge of the substrate along the radial direction of the substrate, when the liquid nozzle moves to a certain area above the substrate, adjust the flow rate of the fluid in the cavity on the radius corresponding to said certain area by controlling the mass flow controller and/or adjust the temperature of the fluid in the cavity on the radius corresponding to said certain area by controlling the heater to make the fluid in the cavity on the radius corresponding to said certain area reaches a second thermal energy, and the fluid with the second thermal energy heats the substrate region corresponding to said certain area to a second temperature through the fluid outlet holes of the cavity on the radius corresponding to said certain area.

13. The substrate processing apparatus according to claim 1, wherein each fluid delivery pipe connected to each cavity is connected to two fluid delivery branch pipes, each fluid delivery branch pipe is connected to a fluid delivery main pipe, an on-off valve is installed on each fluid delivery branch pipe, and a mass flow controller and a heater are installed on each fluid delivery main pipe; wherein,
the on-off valve is configured to open or close the fluid passing through the fluid delivery branch pipes;
the mass flow controller is configured to monitor and adjust the flow rate of fluid passing through each fluid delivery main pipe;
the heater is configured to heat the fluid in each fluid delivery main pipe.

14. The substrate processing apparatus according to claim 13, wherein the control mechanism is configured to:
adjust the flow rate of fluid by controlling the mass flow controllers and/or adjust the fluid temperature by controlling the heaters to make the thermal energy of the fluid flowing through the first fluid delivery main pipe to reach a first thermal energy and the thermal energy of the fluid flowing through the second fluid delivery main pipe to reach a second thermal energy;
open the on-off valves on the first fluid delivery branch pipes, the fluid with the first thermal energy heats the substrate to a first temperature through the fluid outlet holes of each cavity;
during the process of the liquid nozzle moving from the center of the substrate to the edge of the substrate along the radial direction of the substrate, when the liquid nozzle moves to a certain area above the substrate, close the on-off valve on the first fluid delivery branch pipe connected to the cavity on the radius corresponding to said certain area and simultaneously open the on-off valve on the second fluid delivery branch pipe connected to the cavity on the radius corresponding to said certain area, the fluid with the second thermal energy in the second fluid delivery main pipe heats the substrate region corresponding to said certain area to a second temperature through the fluid outlet holes of the cavity on the radius corresponding to said certain area.

15. The substrate processing apparatus according to claim 1, wherein each fluid delivery pipe connected to each cavity is connected to three fluid delivery branch pipes, each fluid delivery branch pipe is connected to a fluid delivery main pipe, each fluid delivery branch pipe is equipped with an on-off valve, and each fluid delivery main pipe is equipped with a mass flow controller, a heater is disposed on fluid delivery main pipes connected to the first fluid delivery branch pipe and the second fluid delivery branch pipe; wherein,
the on-off valves are configured to open or close the fluid passing through the fluid delivery branch pipes;
the mass flow controllers are configured to monitor and adjust the flow rate of fluid passing through each fluid delivery main pipe;
the heaters are configured to heat the fluid in each fluid delivery main pipe.

16. The substrate processing apparatus according to claim 15, wherein after taking the substrate from the clamp mechanism, close the on-off valves set on the first fluid delivery branch pipe and the second fluid delivery branch pipe, open the on-off valve set on the third fluid delivery branch pipe, and supply low-temperature fluid into the fluid delivery main pipe connected to the third fluid delivery branch pipe, the low-temperature fluid passes through each cavity to cool the heating plate.

17. The substrate processing apparatus according to claim 1, wherein each fluid delivery pipe connected to each cavity is connected to three fluid delivery branch pipes, a first fluid delivery branch pipe is connected to a first fluid delivery main pipe, a second fluid delivery branch pipe is connected to a second fluid delivery main pipe, and a third fluid delivery branch pipe is connected to a third fluid delivery main pipe, each fluid delivery branch pipe is equipped with an on-off valve, and each fluid delivery main pipe is equipped with a mass flow controller and a heater; wherein,
the on-off valves are configured to open or close the fluid passing through the fluid delivery branch pipes;
the mass flow controllers are configured to monitor and adjust the flow rate of fluid passing through each fluid delivery main pipe;
the heaters are configured to heat the fluid in each fluid delivery main pipe.

18. The substrate processing apparatus according to claim 17, wherein the control mechanism is configured to:
adjust the flow rate of fluid by controlling the mass flow controllers and/or adjust the temperature of fluid by controlling the heaters to make the thermal energy of the fluid in the first fluid delivery main pipe reach a first thermal energy, the thermal energy of the fluid in the second fluid delivery main pipe reach a second thermal energy, and the thermal energy of the fluid in the third fluid delivery main pipe reach a third thermal energy;
open the on-off valves on the first fluid delivery branch pipes connected to each fluid delivery pipe, the fluid with the first thermal energy heats the substrate to a first temperature through the fluid outlet holes of each cavity;
during the process of the liquid nozzle moving from the center of the substrate to the edge of the substrate along the radial direction of the substrate, when the liquid nozzle moves to a certain area above the substrate, close the on-off valve on the first fluid delivery branch pipe connected to the cavity on the radius corresponding to said certain area, and simultaneously open the on-off valve on the second fluid delivery branch pipe connected to the cavity on the radius corresponding to said certain area, the fluid with the second thermal energy in the second fluid delivery main pipe heats the substrate region corresponding to said certain area to a second temperature through the fluid outlet holes of the cavity on the radius corresponding to said certain area;
at the same time, open the on-off valve on the third fluid delivery branch pipe connected to another cavity adjacent to the cavity on the radius corresponding to said certain area in the radial direction away from the center of the heating plate, the fluid with the third thermal energy in the third fluid delivery main pipe heats the substrate region corresponding to said another cavity to a third temperature through the fluid outlet holes of said another cavity;
the first temperature is lower than the third temperature, and the third temperature is lower than the second temperature.

19. A substrate processing method, comprising:
holding the substrate on a clamp mechanism;
driving the clamp mechanism to rotate the substrate;
dispensing liquid to the substrate surface through a liquid nozzle of a spray head mechanism, during the process of the liquid nozzle moving from the center of the substrate to the edge of the substrate along the radial direction of the substrate, when the liquid nozzle moves to a certain area above the substrate, jetting fluid with a second thermal energy to the bottom of the substrate to heat the substrate region corresponding to said certain area, raising the local temperature of the substrate below the liquid nozzle.

20. The substrate processing method according to claim 19, wherein before dispensing liquid to the substrate surface through the liquid nozzle of the spray head mechanism, the method further includes: preheating the whole substrate by jetting fluid with a first thermal energy to the whole bottom of the substrate.

21. The substrate processing method according to claim 19, wherein while jetting fluid with the second thermal energy to the bottom of the substrate to heat the substrate region corresponding to said certain area, re-preheating the substrate region corresponding to an area adjacent to said certain area in the radial direction away from the center of the substrate by jetting fluid with a third thermal energy to the bottom of the substrate.

22. The substrate processing method according to claim 19, wherein the fluid is gas or liquid.

23. The substrate processing method according to claim 19, wherein controlling the temperature and/or flow rate of the fluid with the second thermal energy to locally heat the substrate region corresponding to said certain area, the local temperature of the substrate below the liquid nozzle is increased.

24. The substrate processing method according to claim 19, further comprising: cooling a heating plate by supplying low-temperature fluid after taking the substrate from the clamp mechanism.

25. The substrate processing apparatus according to claim 3, further comprising:
a heating element setting between the first chuck and the second chuck to heat the fluid in the at least two cavities.

26. The substrate processing apparatus according to claim 25, further comprising:
a cooling mechanism, the cooling mechanism including a cooling part, wherein the cooling part is arranged on the first chuck and used for reducing the temperature of the first chuck.

27. The substrate processing apparatus according to claim 26, further comprising a sealing layer disposed on the upper surface of the first chuck.

28. The substrate processing apparatus according to claim 27, wherein the cooling part is a cooling groove opened on the upper surface of the first chuck.

29. The substrate processing apparatus according to claim 27, wherein the cooling part is a cooling pipe, the upper surface of the first chuck is provided with an accommodating groove, the cooling pipe is set in the accommodating groove, and each of the cavities is correspondingly provided with the cooling pipe.

30. The substrate processing apparatus according to claim 26, wherein the cooling part is a cooling cavity, and the cooling cavity is set inside the first chuck.

31. The substrate processing apparatus according to claim 26, wherein the first chuck is covered with a protective layer.

32. The substrate processing apparatus according to claim 26, wherein the cooling part is a cooling pipe, and an accommodating cavity is set inside the first chuck, and the cooling pipe is set in the accommodating cavity, and each of the cavities is correspondingly provided with the cooling pipe.

33. The substrate processing apparatus according to claim 26, wherein the first chuck is made of metal material;
the second chuck is made of non-metal material.

34. The substrate processing apparatus according to claim 25, further comprising:
a cooling mechanism, the cooling mechanism including a cooling part, wherein the cooling part is disposed on the second chuck, and is used for reducing the temperature of the second chuck.

35. The substrate processing apparatus according to claim 34, wherein the cooling part is a cooling cavity, and the cooling cavity is set inside the second chuck.

36. The substrate processing apparatus according to claim 35, wherein the first chuck is made of non-metal material;
the second chuck is made of metal material.

37. The substrate processing apparatus according to claim 25, further comprising a thermal insulation layer being arranged between the second chuck and the heating element.

38. The substrate processing apparatus according to claim 26 or 34, wherein an inlet of the cooling part is connected to at least one inlet pipe for delivering liquid into the cooling part, and the inlet pipe is equipped with a cooler for cooling the liquid flowing through the inlet pipe;
an outlet of the cooling part is connected to at least one outlet pipe for discharging the liquid from the cooling part.

39. The substrate processing apparatus according to claim 38, wherein the inlet of the cooling part is further connected to at least one inlet gas pipe for delivering gas into the cooling part;
the outlet of the cooling part is connected to at least one outlet gas pipe for discharging the gas from the cooling part.

40. The substrate processing apparatus according to claim 39, wherein an on-off valve is arranged on the inlet pipe, the outlet pipe, the inlet gas pipe and the outlet gas pipe respectively.

41. The substrate processing apparatus according to claim 40, wherein the control mechanism is further configured to control the cooling mechanism to reduce the temperature of the first chuck or the second chuck.

42. The substrate processing apparatus according to claim 41, wherein the control mechanism is further configured to:
open the on-off valves on the inlet pipe and the outlet pipe after the process of heating and drying the substrate is completed;
control the cooler to cool the temperature of the liquid flowing through the inlet pipe, and the cooled liquid enters the cooling part to cool the cooling part for a time period T1 to lower the overall temperature of the first chuck or second chuck to room temperature, and then close the cooler and the on-off valves on the inlet pipe and the outlet pipe.

43. The substrate processing apparatus according to claim 42, wherein the control mechanism is further configured to:
close the cooler and the on-off valves on the inlet pipe and the outlet pipe, and then open the on-off valves on the inlet gas pipe and the outlet gas pipe; control the gas to flow through the cooling part for a time period T2 to dry the cooling part, then close the on-off valves on the inlet gas pipe and the outlet gas pipe.

44. The substrate processing apparatus according to claim 43, wherein the gas supplied into the cooling part is dry gas.
